# EUROPEAN PATENT SPECIFICATION

(11) **EP 3 032 566 B1**
(45) Date of publication and mention of the grant of the patent: **06.11.2019**
(21) Application number: 14196852.9
(22) Date of filing: 08.12.2014
(51) Int. Cl.: H01J 37/34, C23C 14/35, H01J 37/32

(54) **Cylindrical structure for use in an RF sputter process and a sputtering system comprising same**
Zylindrische Struktur zur Verwendung in einem HF-Sputterverfahren und Sputtersystem damit
Structure cylindrique destinée à être utilisée dans un processus de pulvérisation cathodique RF et système de pulvérisation la comprenant

(43) Date of publication of application: 15.06.2016
(73) Proprietor: Soleras Advanced Coatings bvba, 9800 Deinze (BE)
(72) Inventor: De Bosscher, Wilmert, 9031 Drongen (BE)
(74) Representative: DenK iP

(56) References cited:
- US-A1- 2013 008 777
- US-A1- 2014 042 022
- US-A1- 2014 183 037

## Description

### Field of the invention

The present invention relates to the field of sputtering. More in particular, the present invention relates to a cylindrical structure for building rotating sputter targets to be powered by an RF power source, to sputter targets, and to a sputtering system comprising such a sputter target.

### Background of the invention

The technique of material deposition by means of sputtering is known already for many decades, and hence need not be explained in detail here. It suffices to say that typically a plasma is generated in a low pressure chamber in which an inert gas such as Argon , or an active gas such as oxygen or nitrogen is present, and that a high voltage is applied between a so called "sputter target" (containing the material to be deposited) and a "substrate" upon which a layer of the sputter material is to be deposited. The Argon atoms are ionized, and the sputter target is bombarded by the Argon ions, so that atoms are freed from the sputter target, and move to the substrate, where they are deposited.

Basically three kinds of sputter targets are being used: planar circular disk targets, planar rectangular targets, and rotational cylindrical targets.

Typically three kinds of power supply are being used: DC power, AC power (e.g. at a frequency of 5 to 60 kHz) and RF power (e.g. at a frequency of 1 to 100 MHz). DC power is typically used when the sputter target contains an electrically conductive sputter material. AC power is typically used when the deposited layer is less conductive. In the past, when a material with a low conductivity was to be sputtered, one typically added doping atoms to increase the conductivity of the target material.

However, the above-described techniques do not work anymore when an insulating material having a resistivity higher than for example 10 k ohm.cm is to be deposited without being allowed to add dopants, e.g. in applications where even a minor degree of contamination is detrimental for the performance or the lifetime of the deposited layer on the substrate, such as for example electrochromic windows, thin film batteries and solar cell applications, where even minor amounts of conductive particles can cause internal leakage or short-circuiting.

In US2013/0008777A1 Choquette et al. disclose an apparatus for depositing a.o. oxides by using RF power, without the need for metal doping, addressing the contamination issue. Choquette et al. propose a cylindrical rotating sputtering cathode (also referred to as "magnetron") made of a non-magnetic material (such as stainless steel 304) within which a stationary tubular electrode is inserted, along with magnets attached thereto, as can be seen in FIG. 4 of said publication, replicated herein as FIG. 1. However, when using a sputter target (disk or rectangular or cylindrical) with relatively large dimensions (e.g. 2 to 4 meters, or more) in combination with RF frequencies (e.g. 1 to 100 MHz, or more), standing wave effects (SWE) start playing a role, resulting in a non-uniform electrical field, and hence also in a non-uniform deposited layer. While Choquette et al. address the issue of contamination (by employing RF power in combination with an un-doped sputter material) and the problem of heating (by using a cooling liquid and a non-magnetic material for the electrode and the shaft), the problem of "a standing wave effect" is not mentioned, nor addressed. Choquette seems to concentrate on mechanical issues, rather than electro-magnetic aspects.

In US2010/0245214A1 Baek addresses the SWE-problem for a stationary rectangular target, by mixing frequencies (in particular 60.000 MHz and 59.999 MHz) applied to multiple RF feeding points (in particular: two or four, which are applied to the bottom, but not in the corners of the rectangle). However, this solution cannot be readily applied to a rotating cylindrical target, a.o. because the cylinder is rotating.

US2014/0183037 describes an RF sputtering system (replicated herein as FIG. 2) with a rotary target wherein a single power source and a power splitter is used to apply two (same) RF power signals at a frequency of 40 MHz to both ends of the metal backing tube of the target. It is alleged that by doing so a voltage node which would otherwise occur at about 1 m distance from the ends, can be removed, and a more uniform electrical field is created. While the general idea of providing RF power at both ends of the backing tube is described, no specific details are given about how this can be achieved.

US2014/042022 discloses an inverted cylindrical magnetron (ICM) sputtering source (also known as hollow cathode sputtering) with a 3-anode configuration to provide electric field uniformity. However in US'022 the substrate is biased on a continuous or pulsed DC bias.

Hence, there is still room for alternatives and/or for improvement of this system.

### Summary of the invention

It is an object of embodiments of the present invention to provide a cylindrical structure that can be used in a device suitable for RF sputtering in a rotational system.

It is an object of particular embodiments of the present invention to provide a cylindrical structure for a good rotational sputter target suitable for RF sputtering.

It is an object of particular embodiments of the present invention to provide a cylindrical structure for a rotational sputter target for RF sputtering that provides a more uniform electrical field and/or causes a more uniform erosion of the target material and/or causes a more uniform deposited layer on a substrate.

This objective is accomplished by a cylindrical structure according to embodiments of the present invention.

In a first aspect, the present invention provides a cylindrical structure for use in an RF sputter process, comprising: a backing tube comprising or consisting of a layer of an electrically insulating material; and at least one electrode arranged at least partly within or at least partly on top of said electrically insulating material, said electrode being adapted for receiving RF power from an RF power source, wherein the at least one electrode has such a shape and size that a substantially uniform electrical field for sputtering is created outside the cylindrical structure, when used in a sputter system and when being powered, in use, by an RF power source.

With "substantially uniform electrical field" is meant that the ratio of the time averaged maximum amplitude of the waveform and the time averaged minimum amplitude of the spatially distributed electrical field over the cylindrical structure is less than a factor 3.0, preferably less than an factor 2.5, more preferably less than a factor 2.0, even more preferably less than a factor 1.75, e.g. less than a factor 1.50.

With "electrically insulating" is meant that the resistivity of the material of the insulating layer is at least 2 k ohm.cm and preferably higher than 20 k ohm.cm.

According to an advantageous aspect of the present invention, the electrode(s) has/have such a shape and size (and optionally number), and (optionally) feeding point(s) are arranged on the electrode(s) such that, when being powered by an RF power source, a substantially uniform electrical field is created outside of the structure, in particular in the "near field" thereof, e.g. at a distance less than 1/10^{th} of the wavelength corresponding to the applied RF frequency, e.g. less than 2 meter, or less than 15 cm outside of the cylindrical structure.

In contrast to US2013008777 where a longitudinal electrode is inserted inside the backing tube, and in contrast to US2014183037A1, where the backing tube itself is used as the electrode, according to embodiments of the present invention, the electrode(s) is/are arranged in and/or on an electrically insulating material comprised in a backing tube, for example as an outer layer thereof.

It is an advantage of such a cylindrical structure that it may avoid or reduce electrical losses (e.g. due to Eddy currents), and/or magnetic losses, hence has an increased power efficiency.

The electrode(s) may have at least one feeding point, which may be a physical connector, but that is not absolutely required, and RF power may also be applied in another way, e.g. by capacitive coupling.

It is an advantage of such a cylindrical structure that the electrode(s) need not have the same size and/or shape as the backing tube. This allows the backing tube to be optimized for sufficient rigidity and other parameters such as sufficient cooling, and allows the electrode(s) to be optimized for generating a suitable electrical field. It is a particular advantage of providing multiple electrodes, that it offers many degrees of freedom that can be "tuned" for generating a more uniform electrical field, such as e.g. the number of electrodes, the mutual positions of the electrodes, the shape of the electrodes, their thickness, and optionally (if present) also the position of the feeding points of the electrodes.

It is an advantage of particular embodiments of the present invention that the insulating layer can be used to transport an RF signal from one end of the backing tube to a feeding point in between the opposite ends of the backing tube, rather than being obliged to power the electrodes at one of said ends.

The RF power supply may be a power supply for delivering a power of at least 100 Watt at a frequency in the range of 0.3 to 500 MHz, preferably in the range of 1 to 100 MHz, for example about 13.56 MHz or about 27.12 MHz or about 40.68 MHz or 67.80 or about 100.00 MHz and preferably with primary power levels of 1000 Watt or at least 10 kWatt, or at least 50 kWatt, or above.

It is an advantage of some embodiments that the RF power can be delivered via a static inner tube (also referred to herein as "magnet bar") present within the backing tube (e.g. by means of coax cable(s), or via capacitive coupling, or via inductive coupling, or conductively through the cooling water). In other embodiments, the RF power can be delivered via a conductive mounting system, e.g. comprising an electrically conductive flange and an electrically conductive bracket, or an electrically conductive flange with a screw threat or the like.

The RF power may be delivered via two so called "end-blocks", or via a single "end-block".

In an embodiment, the cylindrical structure further comprises an outer layer comprising a sputter material arranged on top of said at least one electrode.

Such a cylindrical structure is in fact a rotatable sputter target, also known as "rotary target" or "cylindrical target".

In an embodiment, the sputter material of the outer layer is an electrically insulating material.

The present invention is particularly suitable for sputtering an electrically insulating material. The sputter material may for example be an oxide, a carbide, a nitride or a ceramic material, preferably being un-doped. The sputter material may have an electrical resistance of at least 2 k ohm.cm (two thousand), for example more than 10 k ohm.cm (ten thousand), for example more than 25 k ohm.cm (twenty five thousand). A material with such a high electrical resistance cannot be sputtered with a DC or pulsed DC or AC power, but can be sputtered by using an RF frequency power.

In an embodiment, the backing tube mainly contains an electrically non-conductive material.

With "mainly contains" is meant that the core of the backing tube is made of a non-conductive material, for example that the backing tube is made entirely of a non-conductive material except for the electrodes and optional interconnections to said electrodes. It means in particular that the backing tube does not comprise a metal cylinder part.

It is an advantage of embodiments wherein the backing tube is mainly made of a non-conductive material that no Eddy currents can flow in the backing tube, induced by the RF field, hence the conduction losses are decreased.

It is an advantage of embodiments wherein the material of the backing tube is furthermore non-magnetic, in that also magnetic losses can be reduced.

It is a further advantage of such a backing tube, when a material is chosen having a thermal expansion coefficient comparable to (or not deviating too much) the coefficient of thermal expansion from the sputter material, so that mechanical stress is reduced.

Preferably the material of the backing tube has a relatively high thermal conductivity, for allowing efficient cooling.

Suitable materials are for example plastics such as high end performance plastics, such as for example VESPEL® commercially available from DuPont, TORLON® commercially available from Solvayplastics, PEEK, or composite materials (pure or filled or fiber reinforced), or ceramics, such as carbides.

It is an advantage of using an electrically insulating material as the backing tube in that the at least one or plurality of electrodes can be deposited directly on the backing tube, e.g. by spraying, e.g. by using a mask for creating a certain electrode pattern. It is a further advantage of using such a material, that it allows easy embedding of electrical interconnections from said electrodes towards the ends of the tube, where the RF power is applied.

In an embodiment, the backing tube comprises an electrically conductive material surrounded by an insulating outer layer.

In this case, the backing tube itself could be for example a metal or metal alloy backing tube (e.g. stainless steel or an aluminum alloy or copper or titanium), upon which an insulating layer is applied.

It is an advantage of using an electrically conductive material in that it typically has a good thermal conductivity, hence an efficient cooling can be achieved.

It is an advantage of embodiments wherein the backing tube is furthermore non-magnetic, in that the power lost due to the varying magnetic field is also reduced.

It is an advantage of a conductive backing tube in that it can be grounded, or connected to a DC voltage or be left electrically floating. When the backing tube is grounded, the backing tube can act as a grounding plane for the electrodes during operation, which may be advantageous for making a low impeding conduction path. A grounded backing tube can also be used as part of a shielded interconnection (like a micro-strip line).

It is an advantage of certain embodiments of the present invention wherein the backing tube is left electrically floating, in that the electrical capacity formed by the electrode(s) and the backing tube over the insulating material is reduced, and hence also the energy losses in said insulating material due to polarization losses can be reduced.

In an embodiment, the insulating layer further comprises a plurality of capacitors, the value of which capacitors varies over the length of the cylindrical structure and is specifically adapted for creating a substantially uniform electrical field when being powered at a predefined RF frequency in the presence of a plasma.

The inventors have found that it is possible to obtain a substantially uniform electrical field, by choosing proper values for the plurality of capacitors, which values may be found by simulation, or in any other way, for example trial and error, or a combination of these techniques.

In a particular embodiment, the backing tube is grounded, and the RF power is applied to only one end of the at least one electrode, and the other end of the at least one electrode is terminated by an electrical impedance.

In an embodiment, the at least one electrode comprises at least one feeding point.

In an embodiment, the cylindrical structure further comprises an inner tube and at least one coax cable or at least one insulated RF conductor extending inside said inner tube over at least part of its length, the coax cable or the insulated RF conductor being connected at one end to said feeding point and being connectable at an opposite end to an RF power source.

In an embodiment, the insulating layer further comprises electrical interconnection means connected at one end to the at least one feeding point, and extending towards an extremity of the cylindrical structure for allowing connection to the RF power source.

It is an advantage that the at least one feeding point of the electrode can be positioned elsewhere than per definition at an end position of the backing tube.

The electrical interconnection means can have several forms, for example a direct connection from the electrode to a conductive ring or flange located at one or both of the ends of the backing tube, or a coax cable extending inwardly from said electrode through the insulating layer towards an RF power supply. The electrical interconnection may also be an embedded conductive bar or rod or "strip line", e.g. a copper track surrounded by two grounded strips, or any combination hereof.

The electrical interconnection is another advantageous aspect of the present invention, in that it allows choosing an RF feeding point different from one of the outer ends, which is a major advantage of the present invention.

For example, in an embodiment having at least one feeding point that is located near an extremity of the cylindrical structure where the tube is mounted by means of an arrangement typically referred to as "mechanical assembly" or "end block", then the electrical interconnection could be for example a copper plate or copper ring directly connected to said electrode, the copper plate being powered by a conductive flange, the interconnection acting as a first feeding point, which may for example be a point connection or a multi-point connection. Alternatively the first feeding point may be connected via a cable, for example a coax cable extending through said first "end block", for example extending inside a stationary inner tube. In yet another embodiment, the first feeding point may be connected via integrated or embedded "strip lines", for example aluminum or copper strips embedded inside the insulating layer, which are routed from the first feeding point to the first "end block" for connection to an RF power supply.

In an embodiment having two end-blocks, and at least two feeding points located near both of the end-blocks, each of the feeding points can be connected to the nearest end-block in any of the above mentioned ways (coax or strip-line or direct connection to copper ring or conductive flange), or in any other way known to the skilled person. The type of connection may be the same for both feeding points, or may be different. For example, one feeding point may be connected via a "strip line", while the other may be directly coupled to a conductive flange and/or copper plate, or connected via a coax-cable.

In an embodiment having only a single end block, and at least two feeding points located near both ends of the cylindrical structure, one of the feeding points may be connected for example via a direct connection to the end block, while the other feeding point may for example be connected to a coax cable extending inside the inner tube, or via one or more "strip lines" or shielded interconnections (such as bars or rods) embedded in the insulating layer.

In an embodiment, the at least one electrode is a single electrode.

This single electrode may be a single cylindrical layer, e.g. made of Copper, Aluminum, Silver, Gold, Zinc, Brass, Aluminum Alloy, Stainless steel 304, or any other suitable material, surrounding a ceramic backing tube, and may optionally have for example a single, two or more feeding points. The single electrode may extend over substantially the entire backing tube.

In an embodiment, the at least one electrode is a plurality of electrodes.

The electrodes may be adapted for acting as RF antennas. The RF-antennas can be any kind of antenna, such as for example, without being limited thereto, monopole antennas and/or dipole antennas, and combinations thereof and may have any preferential shape, e.g. rectangular, square, diamonds, hexagonal.

In a specific embodiment, a plurality of monopole antennas is arranged in an interleaved manner with dipole antennas for creating the substantially uniform electrical field.

In an embodiment, the at least one insulating layer and/or the at least one electrode has a shape and/or size which varies in the axial direction of the cylindrical structure and is specifically adapted for creating the substantially uniform electrical field, when being powered at a predefined RF frequency in the presence of a plasma.

The electrode(s) may have a shape with a varying cross section taken in a plane perpendicular to the longitudinal axis of the cylindrical structure.

In an example, the insulating layer may have a constant inner diameter but a variable outer diameter, so that the electrodes (of a constant thickness) placed thereon will have a non-constant distance with the environment (e.g. the plasma in a sputter device). The variable shape is chosen for creating a more uniform electrical field.

In an example, the insulating layer may have a constant outer diameter, but the electrodes placed thereon have a non-constant thickness, so that distance between the electrodes and the environment (e.g. the plasma in a sputter device) is variable over the length of the electrodes. The variable shape is preferably chosen for creating a more uniform electrical field. An optimal shape can be found by simulations or by trial and error, or by a combination of measurements and simulations, or any combination of these.

In a second aspect, the present invention provides a magnetron assembly comprising: the cylindrical structure according to the first aspect, and a first mounting assembly, e.g. a first "end block", for rotatably mounting said cylindrical structure in a sputtering installation, mounted at one end of said cylindrical structure.

The "mounting assembly" may be a so called "end block", having means for mechanically holding the structure, and/or means (e.g. a motor) for rotating the cylindrical structure, and having means for providing RF electrical power. Optionally the cylindrical structure further comprises magnets and cooling means.

In some embodiments (e.g. without a coax cable), the motor circuitry may be provided for rotating the cylindrical structure in a continuous manner. In other embodiments (e.g. with a coax cable), the motor circuitry may be provided for driving the motor in a back and forth manner.

It is an advantage of rotating the motor back and forth rather than rotating the motor continuously in the same direction, in that it allows the interconnection means (e.g. cable, e.g. coax cable) to be permanently connected from a power source via a stationary channel (e.g. an inner tube) to the rotatable electrode, without breaking it, while allowing a substantially uniform erosion over the entire target surface.

In an embodiment, the magnetron assembly further comprises a second mounting assembly, e.g. a second "end block", mounted at the opposite end of said cylindrical structure.

The second mounting assembly may have a pure mechanical function (supporting the second end of the target, while allowing rotation), and/or can also have a cooling function (when allowing passage of a liquid for cooling).

In certain embodiments of the present invention, the second mounting assembly may also have means for providing electrical power to one or more electrodes. In certain embodiments, at least one of the first and second mounting assembly (or "end block") may be provided for applying an RF power, while the other end block is provided for applying a DC power. In other embodiments both mounting assemblies may be provided for providing RF power.

In particular embodiments, the second end block may be adapted for connecting the at least one electrode to an electrical impedance, e.g. for electrical termination.

In a third aspect, the present invention provides a sputtering system comprising a magnetron assembly according to the second aspect; and at least one RF power supply and an RF matching tuner connected to said at least one interconnection means.

The matching network is typically adapted for increasing the power efficiency of the system, and typically has a predefined time-invariant impedance.

In particular embodiments of the present invention, the matching network has a time-varying impedance, driven in a particular manner for tuning the signal so as to provide a more uniform electrical field and/or a more uniform erosion and/or a more uniform deposition of the sputter material on the substrate.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other aspects of the invention will be apparent from and elucidated with reference to the embodiment(s) described hereinafter.

### Brief description of the drawings

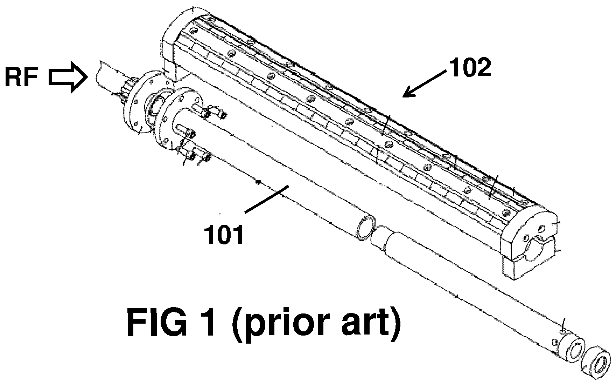

**FIG. 1** shows (in exploded view) a tubular electrode and magnets mounted thereto for insertion inside a non-magnetic backing tube of a rotational target, known in the art.

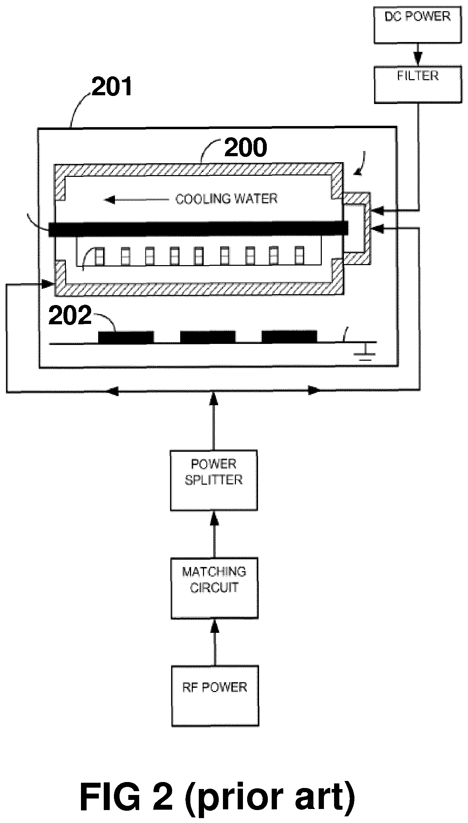

**FIG. 2** is a schematic drawing of a rotational target where an RF power signal is applied to both ends of a metal backing tube, known in the art.

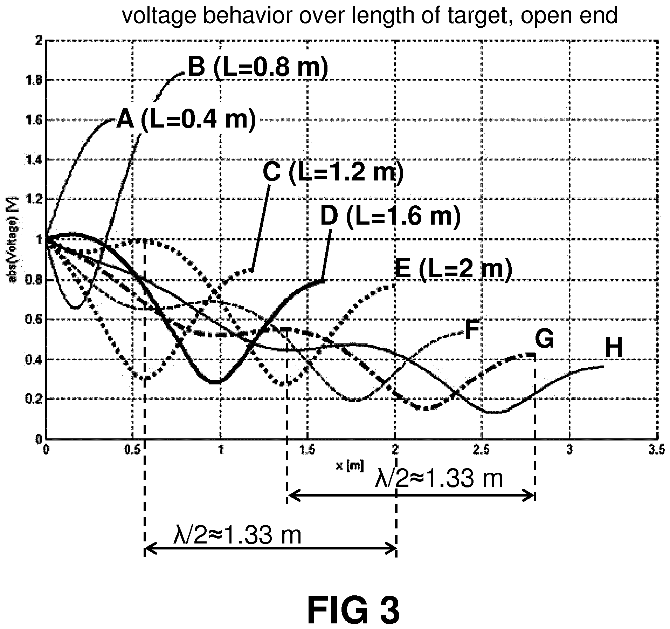

**FIG. 3** shows a simulated voltage amplitude on the outside of a metal backing tube in the presence of a sputter plasma, when an RF signal of 13.56 MHz is applied to one end of the metal backing tube, while the other end of the backing tube is left open. Curves are shown for a backing tube of 0.4m, 0.8m, 1.2m, etc.

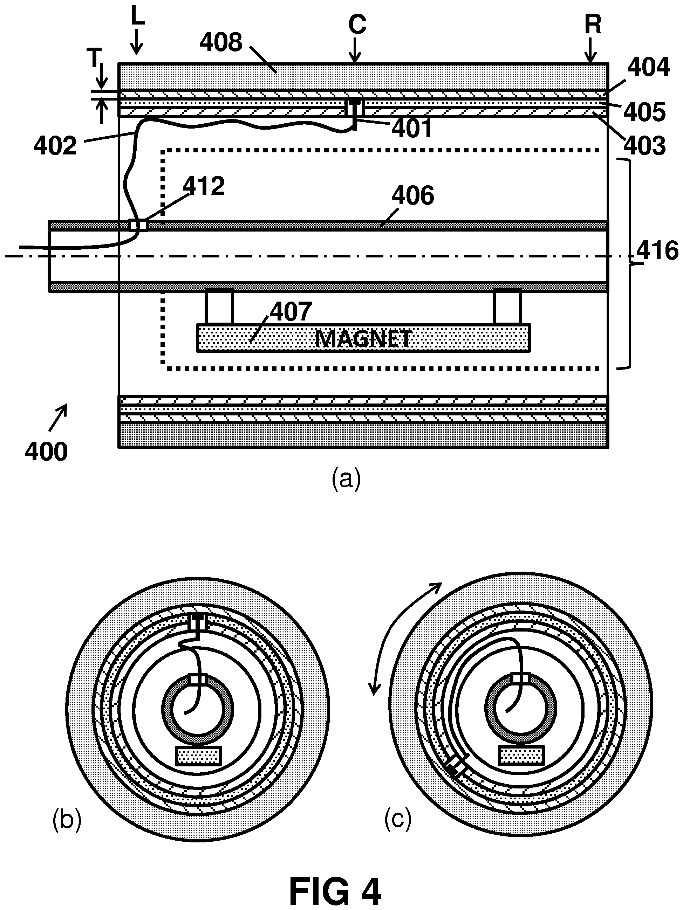

**FIG. 4** illustrates an example of a cylindrical structure or a rotational target according to an embodiment of the present invention, having a metal backing tube, and on top thereof an insulating layer, and on top thereof an electrode with a central feeding point connected to an insulated RF conductor arranged inside the backing tube. FIG. 4(a) is a partial cross-sectional view in a plane containing the central axis, FIG. 4(b) is a cross section in a plane perpendicular to the longitudinal axis when the target is rotated over 0° with respect to a reference position, FIG. 4(c) is a cross-sectional view in a plane perpendicular to the longitudinal axis when the target is rotated over -145° with respect to said reference position.

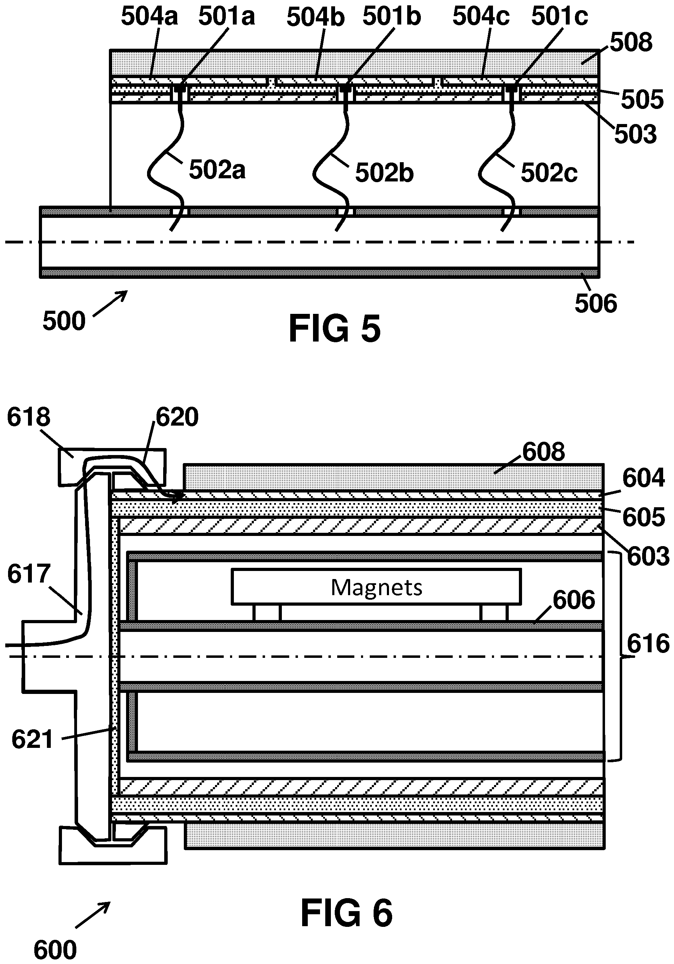

**FIG. 5** illustrates another example of a cylindrical structure or a rotational target according to an embodiment of the present invention, having three cylindrical electrodes electrically insulated from a backing tube by an insulation layer, whereby RF power can be delivered to the individual electrodes via three insulated RF conductors.
**FIG. 6** illustrates another example of a cylindrical structure or a rotational target according to an embodiment of the present invention, whereby RF power can be delivered to one or more electrodes via a conductive flange and/or conductive bracket and one or more conductive bars or rods or strips embedded in, or located on top of an insulating layer located on a backing tube.

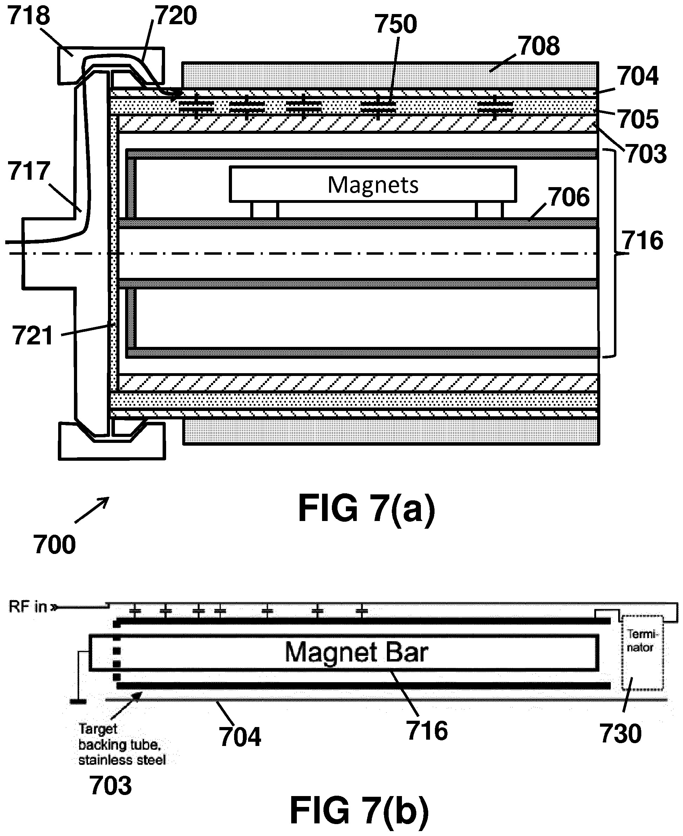

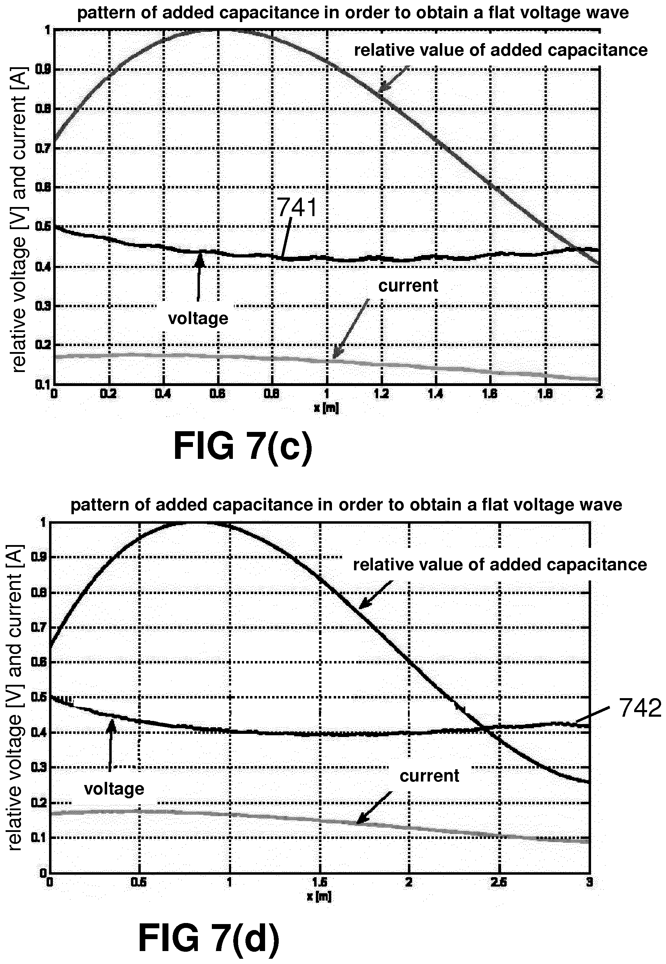

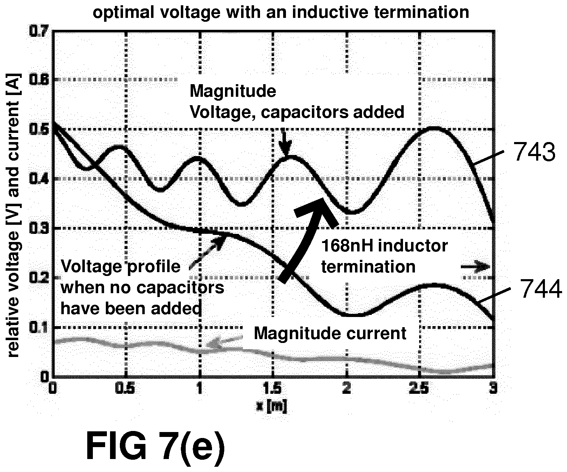

**FIG. 7** shows a variant of the example shown in FIG. 6, having a metal backing tube, and an insulating layer on top of the backing tube, and one or more electrodes on top of the insulating layer, and a non-uniform distributed capacitance arranged between the electrode(s) and the backing tube, adapted for obtaining a more uniform electrical field and/or a more uniform erosion of the target material. FIG. 7(a) shows a schematic diagram. FIG. 7(b) shows an equivalent electrical circuit which can be used in a simulation, for calculating a good, e.g. optimal distributed capacitance over the length of the tube. FIG. 7(c) to FIG. 7(e) show simulations of electrical waves generated by the structure of FIG. 7(a) for particular distributed capacitances.

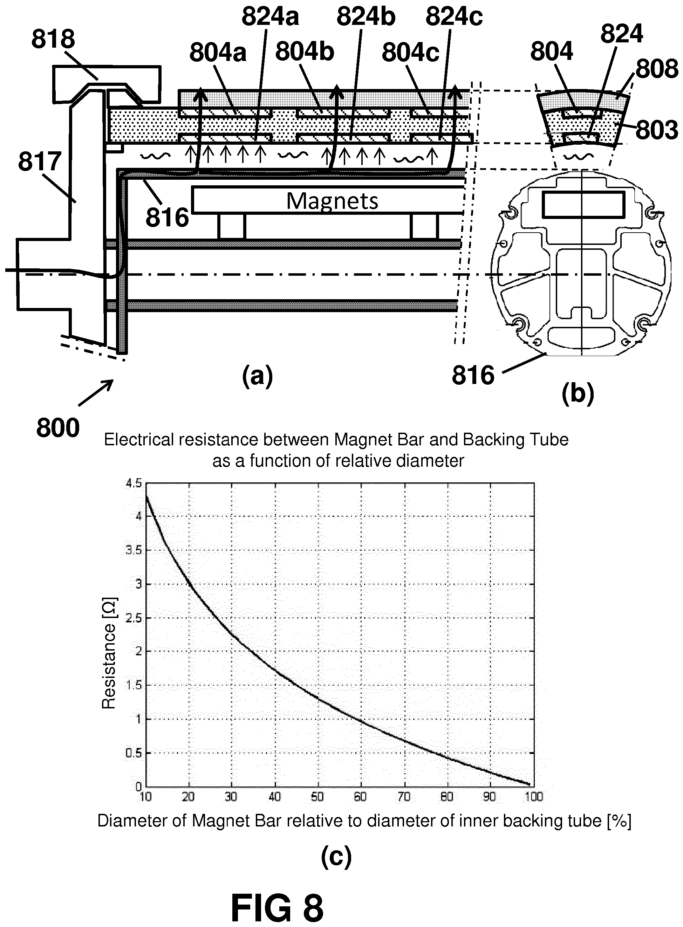

**FIG. 8** illustrates another example of a cylindrical structure or a rotational target according to an embodiment of the present invention, whereby RF power can be delivered to outer electrodes via a conductive magnet bar, through a cooling liquid and via capacitive coupling using electrodes arranged at opposite sides of an insulating backing tube. FIG. 8(a) shows a cross section in a plane containing the longitudinal axis. FIG. 8(b) shows a cross section in a plane perpendicular to the longitudinal axis. FIG. 8(c) shows the electrical resistance between the magnet bar and the backing tube through cooling water as a function of relative diameters.

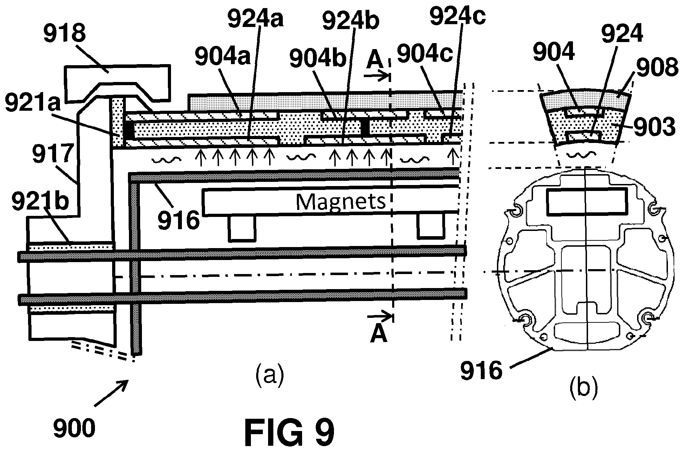

**FIG. 9** illustrates another example of a cylindrical structure or a rotational target according to an embodiment of the present invention, whereby RF power can be delivered to one or more outer electrodes via a conductive magnet bar and a conductive cooling liquid, using inner electrodes located on the inside wall of an insulating backing tube, the inner electrodes and outer electrodes being conductively interconnected. FIG. 9(a) shows a cross section in a plane containing the longitudinal axis. FIG. 9(b) shows a cross section in a plane A-A perpendicular to the longitudinal axis.

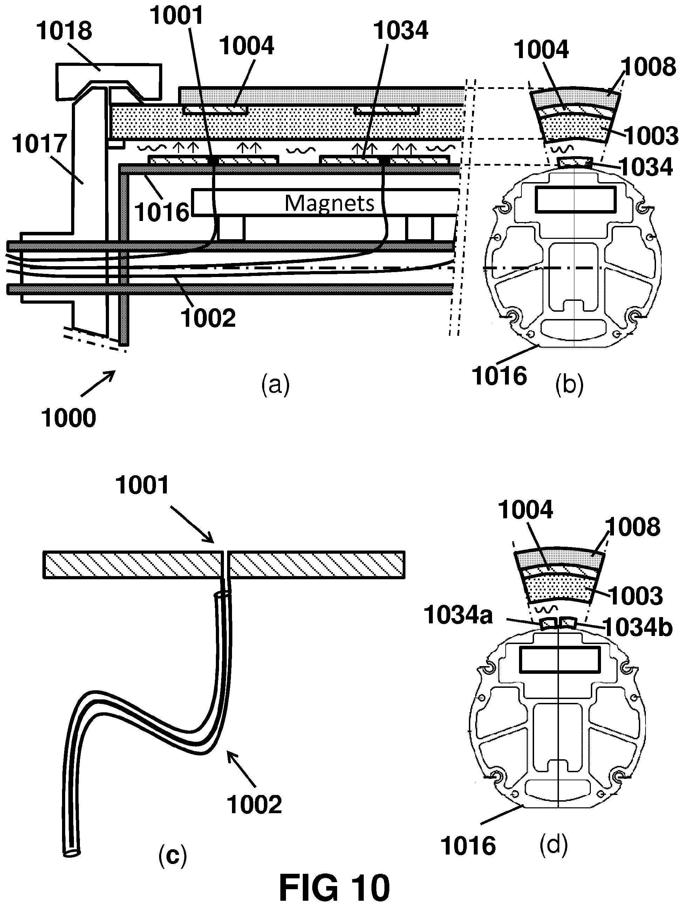

**FIG. 10** illustrates another example of a cylindrical structure or a rotational target according to an embodiment of the present invention, whereby RF power is delivered via shielded cables to a first plurality of inner electrodes arranged on the outer surface of a conductive magnet bar (but electrically isolated therefrom), and whereby a second plurality of outer electrodes are arranged on the outside of the insulating backing tube, adapted for making the electrical field more uniform and/or for causing the target erosion to be more uniform. FIG. 10(a) shows a cross section in a plane containing the longitudinal axis. FIG. 10(b) shows a cross section in a plane perpendicular to the longitudinal axis. FIG. 10(c) shows a preferred connection of a coax cable to a pair of electrodes, arranged as a dipole antenna.

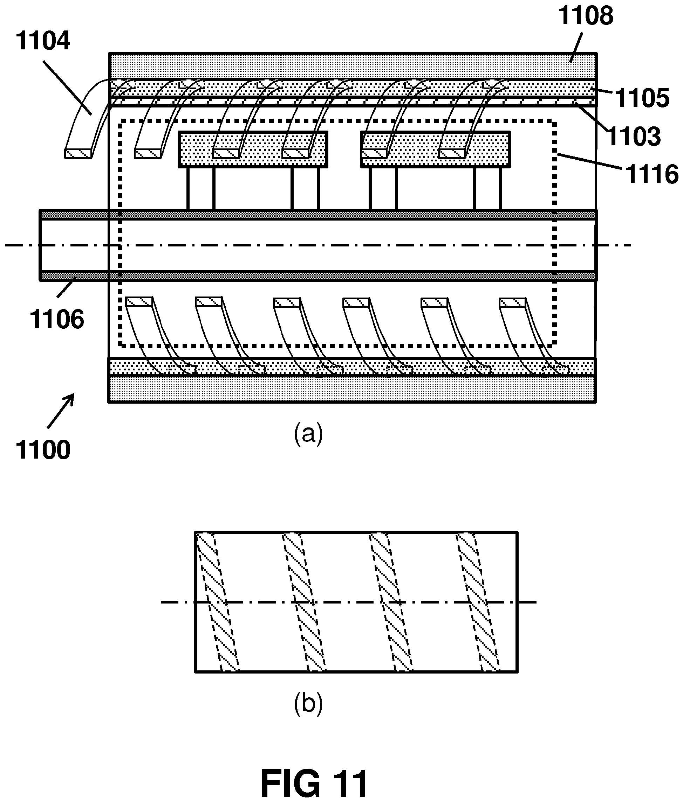

**FIG. 11** illustrates another example of a cylindrical structure or a rotational target according to an embodiment of the present invention, having one or more electrode(s) in the form of a helix organized in or on an insulating layer around the backing tube. **FIG. 11(a)** shows a mixed 3D / cross-sectional view. **FIG. 11(b)** shows a top view for illustrating the position of the helical electrode(s). RF power can be delivered to the helical electrode(s) in any manner shown in FIG. 4 to FIG. 10.

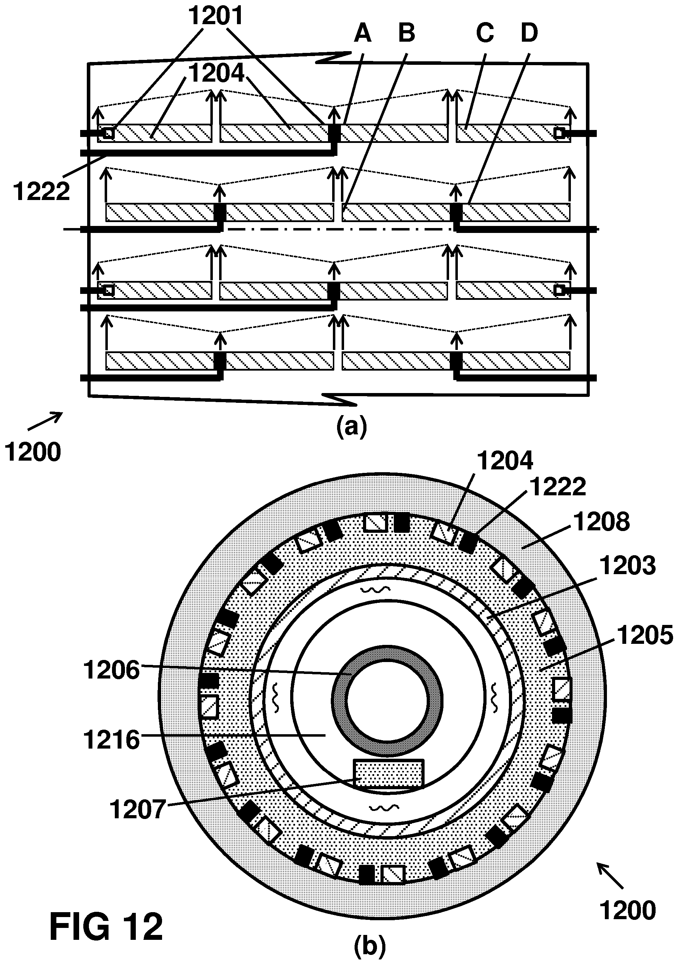

**FIG. 12** shows an example of a cylindrical structure or a rotational target according to an embodiment of the present invention, wherein a plurality of electrodes (acting as antennas) are arranged on an insulating layer forming the backing tube, or an insulated layer located outside of a backing tube. FIG. 12(a) is a schematic view, showing the electrodes and examples of hypothetical waveforms emitted thereby. The power to the electrodes may be delivered from one side or from both sides of the cylindrical structure. FIG. 12(b) shows a cross section of the structure of FIG. 12(a) in a plane perpendicular to the longitudinal axis.

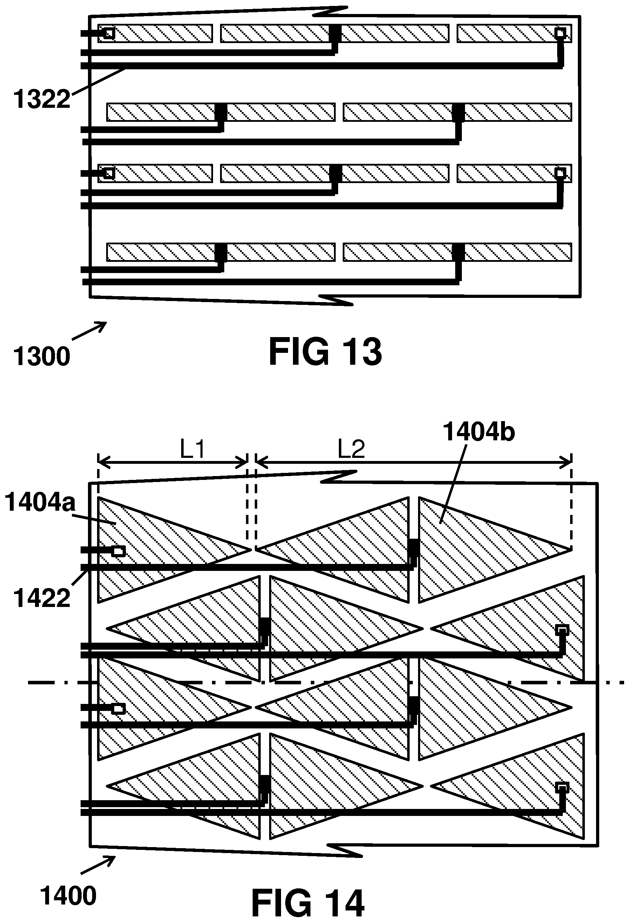

**FIG. 13** shows a variant of the example of FIG. 12, whereby the RF power can be delivered from a single end of the cylindrical structure in the manner shown in FIG. 6.
**FIG. 14** shows another variant of the embodiment of FIG. 12, whereby the electrodes may have different sizes and shapes.

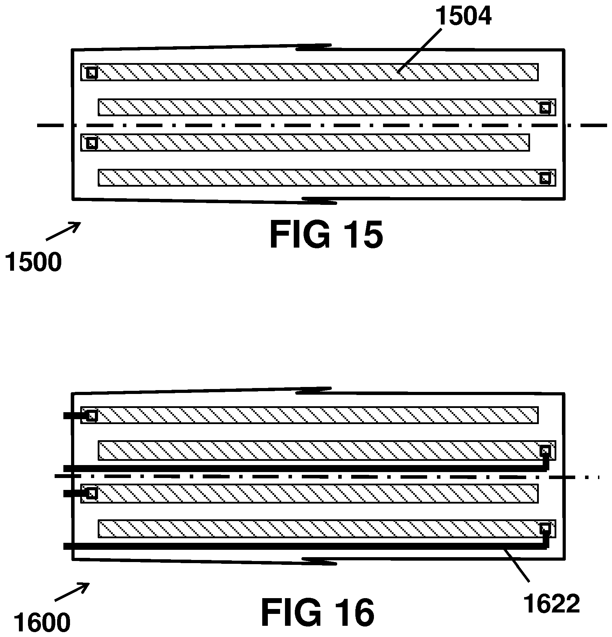

**FIG. 15** shows another variant of the cylindrical structure of FIG. 12, whereby the electrodes are arranged in parallel, and have a predetermined length. The length may be equal to about 1.5 or 2.5 or 3.5 times the wavelength of the standing waveform that will occur when the structure is being powered at 13.56 MHz in the presence of a plasma in a sputter chamber. Adjacent electrodes have feeding points at their opposite ends for receiving RF power from two opposite ends of the structure in the manner shown in FIG. 6.
**FIG. 16** shows a variant of the embodiment of FIG. 15, whereby the electrodes are powered from only one end of the backing tube, using the same feeding points as shown in FIG. 15

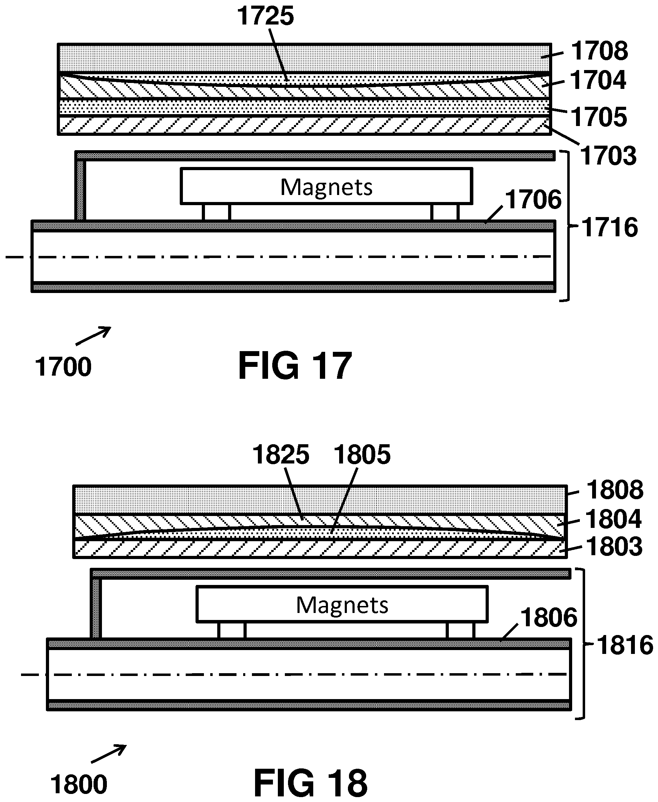

**FIG. 17** shows an example of a cylindrical structure of the present invention, whereby the one or more electrode(s) is "shaped" for providing a varying capacitance in the axial direction of the tube. In the cross-section shown, the electrode is straight at its inner side, but curved at its outer side. The space between the sputter material and the electrode may be filled with a dielectric.
**FIG. 18** shows another example of a cylindrical structure of the present invention, whereby the one or more electrode(s) is "shaped" for providing a varying capacitance in the axial direction of the tube. In the cross-section shown, the electrode is straight at its outer side, but curved at its inner side. The space between the sputter material and the electrode may be filled with a dielectric.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in the present invention reference is made to an "RF signal", a signal having a frequency in the range of 0.3 MHz to 500 MHz is meant.

Where in the present invention reference is made to an "end-block", reference is made to an element or component which is located at an end of a backing tube, and is adapted for holding the backing tube, and for rotating it around its longitudinal axis, but an end block may also have other functions, such as e.g. cooling.

Before describing the present invention, the next few paragraphs will first explain in more detail what an "end block" is.

Large coaters to coat e.g. glass with all kinds of stacks of functional coatings are often equipped with rotating tubular sputtering targets. The target itself is rotating relative to the sputtering system and hence a complex and space occupying 'end-block' is needed to bear, rotate, energize, cool and isolate (coolant, air and electricity) the rotating target while holding the magnet array fixed inside. Several arrangements exist in the art, for example:
- "Double right-angled end-blocks" such as disclosed in US 5096562 (FIG. 2, FIG. 6) and US 2003/0136672 A1 wherein the means for bearing, rotating, energizing, cooling and isolation (air, coolant and electrical) are divided between two blocks, situated at either end of the target. With right-angled is meant that the end-blocks are mounted to the wall that is parallel to the rotation axis of the target.
- "Single, straight-through end-blocks" such as disclosed in US 5200049 (FIG. 1) wherein the means for bearing, rotating, energizing, cooling and isolation are all incorporated in one end-block and the target is held cantilevered inside the large area coater. With 'straight-through' is meant that the rotation axis of the target is perpendicular to the wall on which the end-block is mounted. 'Semi-cantilevered' arrangements are also described (US 5620577) in that the end of the target opposite from the end-block is held by a mechanical support

An end-block links the sputtering target in the sputtering system to the outside of the sputtering system. Such an end-block is typically mountable as a single unit on a sputtering system, although a wall integrated end-block could be envisaged as well. Within part of an end-block the pressure may be higher than in the sputtering system, preferably the pressure inside is close to atmospheric. Means that are removable with the target tube or the removable magnet bar assembly are typically not considered as belonging to the end-block. The primary function of the end-block is to carry and to revolve the target around an axis of rotation. As sputtering is performed under a low gas pressure, the end-block must be gas tight at all times, also during rotation. As the sputtering of the target may generate a lot of heat on the target surface, the target has to be cooled, which is normally done with water or another suitable coolant. This coolant may be fed and evacuated through the end-block. The target may also be fed with an electrical current in order to maintain the target at a certain electrical potential. In order to incorporate all these functions, each end-block may comprise one or more of the following means: (i) drive means to make the target rotate, (ii) a rotatable electrical contact means to provide electrical current to the target, (iii) one or more bearing means to mechanically support the target while allowing rotation around its axis, (iv) one or more rotatable coolant sealing means, (v) one or more rotatable vacuum sealing means, (vi) means for holding the magnets or magnetic array.

FIG. 1 is a replica of FIG. 4 of US2013/0008777 and shows (in exploded view) a tubular electrode 101 and a magnet assembly 102 comprising a plurality of magnets, mounted thereto for insertion inside a non-magnetic backing tube of a rotational sputter target 100. Although mechanical aspects of the sputter target are described, the disclosure does not provide any insights about how the RF power applied to the electrode can reach the outside of the backing tube, how good it works, which parameters can be tuned, etc.

FIG. 2 is a replica of FIG. 2 of US2014/0183037, which is a schematic drawing of a rotational target 200 known in the art, wherein a metal backing tube is provided at both ends with an RF power signal originating from an RF power source via a power splitter. Envisioned frequencies are 13.56 MHz and 40 MHz. The sputter target 200 is arranged in a sputter chamber 201, in the vicinity of substrates 202 upon which sputter material is to be deposited. In the example shown, one end of the backing tube is also connected to a DC power source, via a filter. The electrical field generated by this sputter target, or rather by the backing tube comprised therein, is alleged to be more uniform than the electrical field provided by the solution of FIG. 1, since power is provided at both ends of the backing tube. This may not be immediately noticeable for a target length of about 2 m and an RF frequency of about 13.56 MHz, but is more pronounced when using a target tube of about 2 m and an RF frequency of about 40 MHz, in which case a so called "voltage node" (i.e. a location where the standing waveform has zero voltage) would be formed, at which location the target erosion would be quite different from other locations.

FIG. 3 shows several simulated curves representing the voltage amplitude present on the outside of a metal backing tube (as a function of distance from the feeding point at x=0) in the presence of a sputter plasma, for a given length of the tube, when an RF signal of 1.0 V at 13.56 MHz is applied to one end of a metal backing tube, while the other end of the backing tube is left open (electrically unconnected). However, the inventors do not wish to be bound by any theory or to these particular curves. Curve A, B, C, shows the simulated voltage for a backing tube having a predefined length of 0.4 m, 0.8 m, 1.2 m, etc., respectively. These curves are obtained by simulation, assuming a highly conductive plasma at a short distance (about 3.5 mm) from the target tube.

Such simulation may take into account a capacitive coupling of the electrode to a nearby plasma, whereby the plasma can be modeled as a series connection of a first sheath and a bulk and a second sheath. The simulation can be done for example in a similar manner as described in the thesis "Characterization of a high-density large-area VHF plasma source", by Hannes Schmidt, Thesis Number 3495, presented on 21 April 2006, Centre de Recherches en Physique des Plasmals, Faculty of basic sciences, in Lausanne, which is incorporated in its entirety herein by reference. Reference is made in particular to page 11 to 38 of said thesis, where such analysis is described for a "planar circular disk" target and a "planar rectangular" target, although other terminology is used therein.

Apart from the fact that simulations are only an approximation of reality, and that the true voltages can only be obtained by real measurements, the simulated curves show several interesting aspects:
(a) the voltage on the tube drops significantly over the length of the tube, if the length of the tube is longer than lambda/4;
(b) all the curves have a local maximum at the second (open) end of the tube, rather than at the feeding point;
(c) all the curves have a sinusoidal-like behavior, which is attenuated with increasing distance from the feeding point;
(d) the length of the tube has a major influence on the position of the local maxima and minima;
(e) the "period" of the sinusoidal-like curves appears to be about 2.66 m for all the curves (as indicated for curve F and G).

It is noted that the spatial apparent wavelength found is half of the wavelength of a single running wave over the target. Because of reflection, the frequency is doubled. Whereas the wavelength in vacuum is 22.2 m, the wavelength in the vicinity of the plasma is expected to be about 2.66 m, and because of reflection the apparent spatial wavelength may be about 1.33 m. Because of the damping, it may be slightly larger than that. It is also noted that the waveforms have local maxima and minima, the position of which depends on the length of the backing tube.

Trying to find other solutions for creating an electrical field for RF sputtering, and preferably a more uniform electrical field and/or a more uniform erosion of the target material and/or a more uniform deposition of target material on the substrate, and preferably all of these, the inventors came to the idea of not applying the RF power to the metal backing tube itself, but (directly or indirectly) to individual electrodes located on top of said backing tube, separated therefrom by an electrically insulating layer. Providing a plurality of electrodes, whereby the electrodes may have different shapes, dimensions, orientations, thickness, and optionally different positions of the RF feeding point, etc. provides many degrees of freedom to the structure, which degrees of freedom can be used to obtain a more uniform field, and/or a more uniform erosion of the sputter material, and/or a more uniform deposition on the substrate. This is an underlying idea of the present invention.

In a first part of the description, a number of techniques of how RF power can be applied to one or more electrodes located on a cylindrical backing tube will be described below, with reference to FIG. 4 to FIG. 10. However, the invention is not restricted to these embodiments, in particular to the number, size, shape, arrangement, etc. of the electrode(s) shown in these embodiments.

In a second part of the description, a number of possible electrode arrangements will be described in relation to FIG. 11 to FIG. 16. In the specific examples shown, the RF power is provided in the manner described in relation to and shown in FIG. 6, but the invention is not limited thereto, and these electrode arrangements may also be used in conjunction with other ways of providing RF power, in particular any manner described in relation to FIG. 4 to FIG. 10.

In a third part of the description, an additional feature will be described in relation to FIG. 17 and FIG. 18, which feature may optionally be applied to all embodiments of the present invention, in particular to all of the embodiments described in relation to FIG. 4 to FIG. 16, except when explicitly stated otherwise.

**FIG. 4(a)** shows a first embodiment of a cylindrical structure 400 (illustrated as part of a rotatable sputter target) according to an embodiment of the present invention, in cross-sectional view. The cylindrical structure 400 has a metal backing tube 403 with an insulating layer 405 on top thereof. Alternatively the backing tube 403 is made of an electrically insulating material, e.g. a ceramic material, or a composite material (e.g. a filled composite material or a fiber-reinforced composite material) in which case the additional insulating layer 405 can be omitted, or stated differently: the insulating material may form the backing tube. On top of the insulating layer 405 or the insulating backing tube one or more electrodes 404 is/are arranged. In the embodiment shown in FIG. 4, the electrode 404 has the form of a single cylindrical surface, but the invention is not limited thereto, and other electrode arrangements may also be used.

The cylindrical structure 400 further comprises a feeding point 401 electrically connected to the electrode 404. In the example shown in FIG. 4(a), the feeding point 401 extends through an opening in the insulating layer 405 and an opening in the backing tube 403. The feeding point 401 may be connected to a shielded cable, e.g. a coax cable, but is preferably connected to an insulated RF conductor, e.g. a flat, e.g. relatively thin single conductor, which is routed and connectable to an RF power supply (not shown), so that RF power can be applied to the cable 402, and hence to the electrode 404, for generating an RF electrical field for sputtering the target material 408 arranged on the outside of the electrode 404. The outer ends of the electrode 404 may be left open (i.e. not connected to an electrical impedance), or may be terminated via an impedance.

The cylindrical structure 400 shown in FIG. 4(a) may further comprise a stationary inner tube 406 for mounting one or more magnets 407 for creating a stationary magnetic field, as is commonly known in the art, and/or for conducting a cooling fluid (not shown). Instead of an inner tube 406 on the outside of which magnets 407 are mounted (as is used in the prior art shown in FIG. 1), it is possible to use a cylindrical magnet bar 416 (indicated by dotted line) encapsulating the magnets 407. An example of such a magnet bar is shown in FIG. 8(b), but can also be used here. Such a magnet bar 416 offers the advantage of accurate positioning of the magnets, but also mechanical protection to the magnets 407 against accidental damage by the cable 402, and chemical protection by avoiding direct contact between the magnets and the cooling liquid. In the embodiment of FIG. 4, the inner tube 406 or the magnet bar 416 do not conduct the RF power signal.

In the example of FIG. 4(a), the coax cable 402 or insulated RF conductor, is routed from a feeding point 401 via an opening in the backing tube 403 into an inner space of the stationary inner tube 406, and from there to an RF power supply (not shown). The cable 402 may be arranged near an inner wall of the backing tube 403, and could be connected thereto via appropriate mechanical attachment means. The length of the cable 402 can be chosen such that the assembly comprising the backing tube 403, the insulating layer 405 (if present), the cylindrical electrode 404 and the outer layer 408 with sputter material can be rotated over a predefined angular range, for example about +/- 150° or about +/- 180° or about +/- 360° without breaking the cable 402. (for that reason, the cable is shown with a curled line in FIG. 4). By rotating the cylindrical structure 400 back and forth, a more uniform erosion of the target material will occur. By using cable(s), a sliding contact as is known in the art for DC power, can be avoided, hence contamination due to mechanical movement can be reduced or limited. The mounting of the backing tube 403 is preferably done in such a way that the backing tube 403 and the electrode 404 are electrically isolated from any flanges and/or brackets (not shown), so that no current will flow over such flanges and/or brackets.

**FIG. 4(b)** is a cross sectional view of FIG. 4(a) in a plane perpendicular to the longitudinal axis at a moment in time wherein the target is rotated over 0° with respect to a reference position. **FIG. 4(c)** is a cross-sectional view of FIG. 4(a) in a plane perpendicular to the longitudinal axis when the target is rotated over about -145° with respect to said reference position. The purpose of these two drawings is to show the relative movement of the outer assembly comprising the backing tube 403 (with the electrode 404 etc.) with respect to the inner tube 406 or magnet bar 416, while allowing the cable 402 to remain connected to the moving electrode 404 and the stationary RF power source. Whereas in the prior art the sputter target is typically continuously rotated in a single direction for allowing more uniform erosion of the target material in a circumferential direction, the same effect can be obtained at least to a large degree by the back and forth movement.

Although the electrode 404 of FIG. 4 is a single cylinder extending over the entire length of the backing tube 403, the invention is not limited to this particular shape, and other electrode arrangements can also be used. One particular variant will be described in relation to FIG. 5, but other electrode arrangements for example as described in relation to FIG. 6 to FIG. 18 may also be used in conjunction with RF power applied via one or more cables, e.g. shielded cables such as coax cables, or insulated RF conductors, or any other conductor arrangement suitable for transporting RF power from an RF power source to the feeding point(s).

It should be mentioned however that, in case of a single cylindrical shape extending over the entire length of the backing tube, the thickness T of the electrode 404 should preferably be sufficiently thin, e.g. less than 3.0 times the skin depth of the electrode material at the frequency of 13.56 MHz, e.g. in the range of 0.1 to 3.0 times the skin depth, e.g. in the range of 0.2 to 2.0 times, e.g. in the range of 0.5 to 1.0 times, e.g. about 0.75 times the skin depth at that frequency for the material in question (e.g. Copper, Aluminum, Silver, etc.), to allow pass-through of the RF current from the inner side of the electrode 404 to the outer side of the electrode 404 through the electrode material itself. If the thickness T is much larger than the skin depth, for example at least 10 times larger, the RF current cannot simply pass through the material, but has to travel around the electrode in a very thin layer at an outer surface thereof, due to the "skin effect". It is evident that in this case the envelope of the electrical signal will strongly depend on the size and shape of the outer electrode.

In each case, when feeding RF power in the middle of the electrode, in particular an electrode that is sufficiently thin to allow pass-through of the RF-signal, it is clear that the voltage waveform will be symmetrical in the middle of the tube (indicated by letter "C"), which may provide a more uniform electrical field and/or a more uniform erosion than is possible with the prior art structure shown in FIG. 1.

In a variant (not shown) of the embodiment of FIG. 4(a), it is also possible to provide more than one feeding point 401 to the cylindrical electrode 404, preferably located at more than one central position "C" of the electrode 404, that is, preferably located at positions in the cross section of said electrode 404 with a plane perpendicular to the axial direction, substantially halfway its length, for example two feeding points at an angular distance of about 180°, or three feeding points at an angular distance of about 120°, or four feeding points at an angular distance of about 90°. The multiple cables 402 may pass through a single opening 412, or a plurality of openings 412 may be foreseen in the inner tube 406 or magnet bar 416. Using multiple cables offers the advantage that less power needs to be delivered via each interconnection 402, so that the cross-sectional area (or diameter in case of a circular conductor) can be reduced, hence their flexibility can be increased. In this case, preferably the same signal (same frequency, same amplitude, same phase) is provided to each of the feeding points 401.

In another variant (not shown) of the embodiment of FIG. 4(a), the electrode 404 has two feeding points, which may e.g. be located at 1/3 and 2/3 of the axial length, and one of these feeding points is supplied with a first RF signal having a frequency of 13.56 MHz, and the other feeding point is supplied with a second RF signal having the same or a second frequency different from the first frequency, (which may be one or more harmonics of the first frequency, but that is not required), whereby the first and the second RF signal have an appropriate frequency and/or phase and/or amplitude chosen such that the combination of both power signals provides a more uniform electrical field.

**FIG. 5** shows (part of) a second example of a cylindrical structure or a rotational target 500 according to an embodiment of the present invention. This cylindrical structure 500 has three individual cylindrical electrodes 504a, 504b, 504c, electrically separated from each other, and being powered individually via respective feeding points 501a, 501b, 501c, shown here in a central position of each electrode, but the invention is not limited thereto. The cylindrical segments may have the same or may have different lengths (in axial direction), and they may be powered by the same RF signal (e.g. using an RF power splitter) or by means of different RF signals (e.g. having a different phase and/or frequency).

The three power signals may for example be generated by a single power supply unit and a power splitter, or they may be generated by two or more separate power supply units. In the latter case, the waveform generated by the second and/or third power supply can be substantially the same (in amplitude, frequency and phase), or may have a different amplitude and/or different frequency and/or different phase) as the first power supply unit. The frequency may be constant or time-varying (known as "frequency sweep") within a predefined frequency range. The phase may be constant or time-varying, for example by making use of an adaptable tuner.

In the embodiment shown, each feeding point 501 is connected via a corresponding cable 502, e.g. coax cable or insulated RF conductor, to one or more external power sources (not shown), for example to three separate RF power sources, or for example to a single power source via a power splitter. In the latter case the same signal would be applied to each individual cylindrical electrode 501. In an embodiment the lengths of the cables 502a, 502b, 502c are chosen substantially the same, so that the signals arriving at the three feeding points 501a, 501b, 501c are in phase. It is noted that the magnets, cooling circuitry etc. are omitted from this drawing, in order not to overload the drawing. The lengths of the individual electrodes 504, and the characteristics (amplitude, frequency, phase) of the three RF signals applied, and the lengths of the cables 502 are chosen so as to create a more uniform time averaged electrical field, hence a more uniform erosion and a more uniform deposition is obtained. The backing tube 503 and electrodes 504 should be electrically isolated from any flanges (not shown), so that no current will flow over such flanges.

Of course, the invention is not limited to only three cylindrical electrodes 504, but would also work with more than three cylindrical electrodes, for example at least five cylindrical electrodes or at least ten cylindrical electrodes 504. By keeping the cylindrical segments 504 separated, it is possible to obtain a more uniform electrical field than is the case with only a single backing tube and only one feeding point, as was the case in FIG. 4. The different RF signals may have different frequencies, or may have the same frequency, e.g. 13.56 MHz but different phases. The feeding points 501 need not necessarily be located in a central position.

But the embodiment of FIG. 5 is not limited to cylindrical electrodes 504, and other shapes may also be possible, for example antenna-shapes such as shown in any of FIG. 12 to FIG. 16, or any other suitable shape.

**FIG. 6** shows another example of a cylindrical structure 600 (in the embodiment illustrated as part of a rotatable sputter target) according to an embodiment of the present invention, in cross-sectional view. Similar to the embodiment of FIG. 4(a), the cylindrical structure 600 has a metal backing tube 603 and an insulating layer 605 on top thereof, and one or more electrodes 604 isolated from said backing tube 603 by means of said insulating layer 605. There is also a stationary inner tube 606 or magnet bar 616 for mounting magnets and for providing a cooling liquid. But the main difference with FIG. 4(a) is that RF power is not supplied via a cable to the electrode(s) 604, but via a conductive mounting assembly, e.g. comprising a conductive flange 617, and a conductive set (consisting e.g. of a single fixation ring or e.g. of more than one segments) of brackets 618, which are clamped to the at least one electrode 604, as schematically indicated by the black arrow 620 (representing the RF current flow). The particular shape of the flange 617 and brackets 618 is not important, (it could e.g. be implemented by a backing tube 603 having an external screw thread, and the bracket 618 having an internal screw thread), but what is important in this embodiment is that the mounting assembly is electrically conductive, and electrically connected to the electrode 604, either directly (at an outer end thereof) or indirectly (e.g. via a bar or strip). The latter will be described further. (It is noted that the flange 617 and the bracket 618 and an insert are shown at some distance from each other for illustrative purposes only. Other details such as O-rings etc. are omitted for the same reason).

Rather than contacting the one or more electrodes 604 located on the backing tube 603 directly, the flange 617 and bracket 618 (or the mounting assembly in general) may contact a conductor, e.g. in the form of a bar or a rod or a strip or the like, which is at least partly embedded in the insulating layer 605, and which is preferably shielded between two ground strips or ground planes (not shown), one of which may be formed by the backing tube 605. In this way, the RF signal 620 can be provided via a shielded interconnection (preferably embedded or incorporated or comprised in the insulating layer 605) to a feeding point of the electrode 604 located at a distance from the flange 617. It is noted that the feeding point need not be a physical connector, but may be any location of the electrode where the RF power is applied, e.g. by contact with the bracket 618 or a conductive ring (not shown). Examples of such interconnections will be discussed in relation to FIG. 12 to FIG. 16. Such interconnection can e.g. be made of aluminum or copper. Providing power via the mounting assembly, e.g. a flange 617 and bracket 618, offers the advantage that (a) cable(s) can be avoided, as well as (an) opening(s) in the insulating layer 605 and in the backing tube 603. Power can be delivered to the conductive flange 617 and/or conductive bracket 618 in any known way, for example via a sliding contact or in any other known way. Another advantage is that the rotation of the cylinder 603, 604, 605, 608 is not restricted to a back and forth movement, because there is no cable anymore passing through the stationary inner tube 606 or magnet bar 616.

The backing tube 603 and the inner tube 606 are preferably electrically isolated from the conductive flange 617 (as schematically illustrated by the isolation layer 621). This allows the inner tube 606 or magnet bar 616 and/or the backing tube 603 to remain electrically floating or at ground potential, or even at a (negative) DC potential, if so desired. The stationary inner tube 606 or magnet bar 616 can readily be connected to a DC power supply in a conventional manner, if so desired, for example via a second flange (not shown).

While only two points of contact are shown in the cross sectional drawing of FIG. 6, it is of course possible to provide multiple connections between the conductive flange 617 and conductive bracket 618 to the single (e.g. cylindrical) or to multiple (e.g. longitudinal) electrodes 604 or to the above mentioned interconnections in the form of a bar or rod or strip or the like. To this end, the mounting assembly may further comprise a conductive ring (not shown), e.g. a copper ring to provide a good contact between the parts of the mounting assembly 617, 618 on the one hand, and the electrodes 604 and/or interconnecting lines on the other hand.

In a variant (not shown) of the embodiment shown in FIG. 6, the electrode 604 may be powered from both ends, for example using two "end blocks", with the same or different RF signals.

**FIG. 7(a)** shows a variant of the embodiment of FIG. 6, whereby a non-uniformly distributed capacitance is present between the conductive backing tube 703 and the cylindrical electrode 704. As explained above, the thickness of the electrode 704 (e.g. conductive layer 704) must be "sufficiently thin" as compared to the skin depth (for the electrode material and the RF frequency chosen) for allowing the RF signal to pass through the electrode material. For example, the thickness should be less than 3.0 times the skin depth, preferably less than 2.0 times the skin depth, preferably less than 1.0 times the skin depth, for example less than 0.5 times the skin depth at 13.56 MHz of the electrode material chosen, which may be e.g. Copper, Aluminum, Silver, Gold, Zinc, Brass, Aluminum Alloy, Stainless steel 304, or any other suitable material. In order to achieve a substantially uniform electrical field, e.g. an electrical field having a substantially constant average amplitude over time and over the length of the target tube, the capacitance needs to be distributed along the length of the cylindrical structure in a particular way, which can be determined based on simulations, or may be based on trial and error.

The inventors used the electrical equivalent circuit shown in **FIG. 7(b)** to perform a simulation, along with a model of the plasma as described above (in relation to FIG. 3). The backing tube 703 was grounded in the simulation, and the electrode was terminated at the second end with a terminating impedance 730, which may be resistive, capacitive or inductive or any combination thereof. By using the well-known software package Mathlab®, the voltage and current waves were simulated for a given constant capacitance distribution. By using a script, the distributed capacitance was then incrementally adjusted with the aim of achieving a substantially uniform electrical field, which is a technique known per se in the art. For a backing tube having a length of 2.0 m, an optimal result (for the voltage waveform) was found for a terminating resistive impedance of 4 Ω. The input impedance was 3 Ω.

The optimal capacitance distribution found in order to obtain a substantially uniform electrical field, is shown in **FIG 7(c)****,** as are the voltage and current amplitudes (averaged over time). As can be seen, according to the simulation, the ratio of the maximum voltage amplitude over the minimum voltage amplitude is less than about 1.25 over the entire length of the tube, which is better than was hoped for.

**FIG. 7(d)** shows a similar simulation for a backing tube of 3.0 meter length, and assuming a target inductance of 0.47 nH/m. The optimum result was found for an end termination impedance of 4.7 Ω towards ground. The input impedance was 3 Ω. The required capacitance for obtaining an optimal voltage profile is plotted as a function of the axial position X. The time-averaged voltage and current amplitudes are also shown. According to the simulation, also here, the voltage amplitude varies between 0.5 V and 0.4 V, which is a relatively small variation of only +/-10% around 0.45 V, but of course the invention is not limited to these particular values, and other values may also be used/found in practice. It was noted that the optimal shape of the distributed capacitance depends strongly on the inductance value of the target tube, which was assumed to be 0.47 nH/m, but the inventors do not wish to be bound to this value, because the real value needs to be determined from measurements or experiments. The same applies for other assumptions used in the simulation, such as e.g. the dimensions of the plasma layers. Therefore, the inventors do not wish to be bound to the particular optimal curves shown in FIG. 7(c) and FIG. 7(d), but to the underlying idea that an optimal capacitance distribution can be found for a particular sputter target having a structure as shown in FIG. 7(a).

The optimization process was repeated for the structure of FIG. 7(b) having a length of 3.0 m, terminated by a reactive load of 168 nH. The optimal result for this case is indicated by curve 743 in FIG. 7(e), which is not as uniform as the curve 742 of FIG. 7(d), but still is a major improvement as compared to the curve 744 which is a copy of curve "H" of FIG. 3, representative of the same structure but without end termination and without added distributed capacitances. Based on the simulation results, the voltage of this wave varies between 0.5 V and 0.3 V, rather than between 0.5 V and 0.1 V, but of course the invention is not limited to these particular values or these particular curves. Using an inductive load is advantageous with regard to power efficiency, but it was found that some standing waves (local minima and maxima) occur, which cannot be completely removed by using specific profile of additional capacitance.

In a variant (not shown) of the embodiment shown in FIG. 7(a), the electrode 704 may be powered from both ends, for example using two "end blocks", with the same or different RF signals.

The capacitors 750 may comprise discrete capacitors, e.g. SMD capacitors, mounted for example on a plurality of Printed Circuit Boards, preferably flexible PCB's, or even on a plastic substrate, because the temperature of the metal backing tube 703 can easily be maintained at a temperature below 70°C, e.g. below 50°C by the cooling water, despite that the temperature on the outside of the layer 708 with sputter material can be much higher.

**FIG. 8** shows another example of a cylindrical structure 800 (in the example illustrated as part of a rotatable sputter target) according to an embodiment of the present invention, in cross-sectional view. The cylindrical backing tube 803 of this embodiment comprises an insulating material and a plurality of (outer) electrodes 804, but additionally comprises inner electrodes 824 arranged on the inside of the insulating backing tube 803 for forming a plurality of capacitances in conjunction with the outer electrodes 804. The outer and inner electrodes 804, 824 are not directly electrically connected to each other, but are separated by the insulating material. The cylindrical structure 800 further comprises an electrically conductive magnet bar 816 which surrounds the magnets and which has internal channels for conducting cooling liquid. The magnet bar 816 has an outer diameter which is slightly less than the inner diameter of the backing tube 803, sufficiently large for allowing passage of cooling water, but sufficiently small for allowing passage of RF energy from the magnet bar 816 to the capacitors formed by the outer and inner electrodes 804, 824.

As shown in FIG. 8(a) the RF current passes through the cooling liquid, for example cooling water, which will cause Joule heating. The amount of heating depends largely on the distance the RF current has to travel through the cooling liquid. FIG. 8(c) shows the electrical resistance for cooling water as a function of the ratio of the outer diameter of the magnet bar 816 and the inner diameter of the backing tube 803. In preferred embodiments of the present invention, the outer diameter of the magnet bar 816 is sufficiently large so that this ratio is at least 90%, but preferably about equal to 95%. In this case the electrical resistance through the water is about 0.1 Ohm, which corresponds to a power loss of about 1 kW if an RF current of 100 A is used. It is noted that the ratio of the diameters of the prior art structure shown in FIG. 1 is about 35%, which means that the water present in the backing tube of FIG. 1 will form an electrical resistance of about 2 Ohms, which will result in a power loss of about 20 kW when using a current of 100 A, which is a factor of 20 more energy loss in the water. Besides the mechanical and chemical protection of the magnets, and the ability to accurately position the magnets, the reduced Joule heating is another major advantage of using a magnet bar 816 such as the one shown in FIG. 8(b) with a relatively large outer diameter. This aspect is also relevant for the embodiments of FIG. 9 and FIG. 10.

During operation, RF power is applied to the magnet bar 816, for example at a frequency of 13.56 MHz. Due to the skin effect, the RF current will flow primarily on the outer surface of the magnet bar 816, and energy can be delivered to the outer electrodes 804 through the cooling liquid and via the inner electrodes 824 by capacitive coupling. Although not explicitly shown, the flange 817 and/or bracket 818 are preferably electrically isolated from the magnet bar 816.

The embodiment of FIG. 8(a) offers the advantage that the RF power can be applied to the stationary magnet bar 816, while allowing rotation of the backing tube 803 (and electrodes 804, 824 located thereon). No cables are needed, no back and forth movement is required, and no power needs to be delivered to the mounting assembly, e.g. flange 817 and/or bracket 818.

In a variant (not shown) of the embodiment shown in FIG. 8, the magnet bar 816 may be powered from both ends, for example using two "end blocks", with the same or different RF signals.

In the drawing of FIG. 8, all the electrodes 804, 824 have the same size and shape, but that is not required, and the size and/or shape of each of the inner or outer electrodes may be different. By appropriately choosing the size and/or position of the inner and outer electrodes 804, 824, and optionally also the kind and/or thickness of the dielectric material there between, the electromagnetic field around the cylindrical structure 800 (e.g. sputter target), can be modified so as to create a more uniform field when placed in a sputter chamber, in the vicinity of a plasma, and when an RF power of a predefined frequency, e.g. 13.56 MHz is applied. For example, it is possible to form larger or smaller capacitances at locations corresponding to local maxima or minima of the RF waveform present on the magnet bar 816. Hence, the location and/or size and/or geometry of the inner and outer electrodes can be used to locally attenuate the waveform, thereby creating a more uniform electrical field. In an embodiment, the size and shape of the inner and outer electrodes may be substantially constant for electrodes having substantially the same axial position (but different angular position on the backing tube), but may vary with the axial position (X-direction). The outer electrodes 804 may be larger than the inner electrodes 824, or vice versa. The electrodes may e.g. be substantially rectangular or square or have a diamond-shape or a polygonal shape (but slightly bended with the curvature of the backing tube).

A particularly interesting configuration is a hexagonal shape for both the inner and outer electrodes, whereby the center points are located at regular intervals spread over the inner and outer surface area, and whereby the diameters of the hexagons are modified as a function of the axial position X for varying the capacitance formed thereby.

**FIG. 8(b)** shows part of the cylindrical structure of FIG. 8(a) in cross section in a plane perpendicular to the longitudinal axis. It shows in particular an example of a possible geometry of an electrically conductive magnet bar 816 having a substantially cylindrical outer surface, which is very well suited for the present application.

**FIG. 9** shows another example of a cylindrical structure 900 (illustrated as part of a rotatable sputter target) according to an embodiment of the present invention, in cross-sectional view. The cylindrical backing tube 903 of this embodiment comprises an insulating material and a plurality of outer electrodes 904 and inner electrodes 924 arranged on the outside, resp. on the inside of the insulating backing tube 903, e.g. on its outer surface and inner surface. In contrast to the embodiment shown in FIG. 8, in this case the outer electrodes 904 and the inner electrodes 924 are electrically interconnected. During operation, an RF power is applied to the magnet bar 916, the RF current (schematically indicated by a black arrow) will flow mainly on the outer surface of the magnet bar 916 due to skin effect, will pass through the conductive liquid, via the inner electrode(s) 924, and will flow to the outer electrodes 904. It is noted that the inner electrode(s) 924 need not extend over the entire length of the cylindrical structure, and a plurality of electrodes having a relatively short length (e.g. about 0.5 meter) can also be used. In the example shown, the flange 917 and the bracket 918 need not be electrically conductive, and may be electrically isolated from the magnet bar 916 by an insulator 921b, and from the electrodes 904, 924 by means of an insulating ring 921. Like for the embodiment of FIG. 8, the ratio of the outer diameter of the magnet bar 916 and the inner diameter of the backing tube 903 is preferably at least 90% to limit energy loss through the cooling liquid.

**FIG. 10** shows another example of a cylindrical structure 1000 (illustrated as part of a rotatable sputter target) according to an embodiment of the present invention, in cross-sectional view. The backing tube 1003 is made of an electrically insulating material, and comprises outer electrodes 1004 embedded in, or mounted on the insulating backing tube 1003. The cylindrical structure 1000 further comprises a stationary inner tube 1016, which preferably comprises magnets, although this is not absolutely required. On the outer surface of the inner tube 1016 a plurality of electrodes 1034 are mounted, each electrode having at least one feeding point 1001 (schematically indicated by a black square), connected to an RF conductor 1002. The electrodes 1034 are preferably electrically isolated from the inner tube 1016, and have a suitable size and shape for functioning as RF antennas, e.g. monopole antennas, dipole antennas, or any other form of antenna. A plurality of outer electrodes 1004 are shaped and sized and arranged in such a way as to form a more uniform electrical field between the target material 1008 and the plasma (not shown) during operation.

During operation, RF power can be distributed via a plurality of cables to a plurality of electrodes 1024 arranged along the length of the central static bar 1016

In the specific embodiment shown in FIG. 10(b), the inner electrodes 1034 are dipole antennas, spaced apart in the axial direction of the tube, and are mounted on the outer surface of the inner tube 1016, but electrically insulated therefrom. Dipole antennas are expected to give the highest field intensity at their ends. The electrodes 1004 arranged on the outer surface of the backing tube 1003 have the form of a cylinder, and are located over (when overlapping) or between (when not overlapping) the outer ends of the inner electrodes 1034. Their purpose is to attenuate the signal by acting as a capacitor, so as to compensate for the higher signal amplitude in the middle of the dipoles.

**FIG. 10(c)** shows an example of a dipole antenna with two legs being physically separated, whereby one leg is electrically connected to the inner conductor of the coax cable 1002, and the other leg is connected to the shielding of the coax cable, as is well known in the art.

It is pointed out, however, that there is a choice of connecting the central conductor of the coax cable to the "left" or "right" side of the dipole antenna, while the shielding is connected to the other part of the dipole antenna. Considering that the embodiment of FIG. 10 has a plurality of dipole antennas, it may make a difference whether always the same side (e.g. the "left" side shown in FIG. 10) of the dipole antenna is always connected to the inner conductor of the coax cables and the other side (e.g. the "right" side shown in FIG. 10) is always connected to the shielding of the coax cable, or whether alternatingly the "left" resp. "right" side is connected to the "inner conductor" resp. the "outer shielding" of the coax cable. By alternating the connection of neighboring dipole antennas, the electrical field strength at the antenna ends may be reinforced. Such alternating connection may also be applied to the embodiments shown in FIG. 5, FIG. 12, FIG. 13 and FIG. 14.

**FIG. 10(d)** shows another optional feature, whereby two parallel arrays of dipole antennas 1034 are mounted on the inner tube 1016, and whereby neighboring dipole antennas are shifted over half a dipole length, similar to the arrangement shown in FIG. 12(a). Such arrangement may automatically average out the higher intensity at the ends. Two such neighboring and axially shifted dipoles 1034a, 1034b are shown in FIG. 10(d) in cross section.

In summary, referring back to FIG. 4 to FIG. 10, several ways are described of how RF power can be applied to one or more electrodes present on a cylindrical backing tube comprising an insulating layer. FIG. 4 and FIG. 5 showed cable-connections (e.g. coax cables or insulated RF conductors) routed via the stationary inner tube, FIG. 6 and FIG. 7 showed a conductive connection via a rotating flange, FIG. 8 and FIG. 9 showed application of an RF current to the stationary inner tube and capacitive coupling to the outer electrodes via a cooling liquid, FIG. 10 showed further electrodes 1034 arranged on a stationary inner tube, supplied with RF power via cables.

In the rest of this document, the focus will be on the size and shape of the electrodes, rather than the manner in which RF power is applied thereto. Although the embodiments shown in FIG. 11 to FIG. 16 are illustrated with one kind of RF supply, it is explicitly stated that the electrode arrangements shown in FIG. 11 to FIG. 16 may also be powered in other ways, such as those shown in any of FIG. 4 to FIG. 10. Of course, conductive paths such as cables etc. should be added or deleted from the drawings depending on the particular implementation being used.

Below, some particularly interesting configurations for the outer electrodes will be described with reference to FIG. 11 to FIG. 16.

**FIG. 11** shows an example of a cylindrical structure or a rotational target 1100 according to an embodiment of the present invention, having a single electrode 1104 or a plurality of electrodes 1104 in the form of a helix arranged around a backing tube 1003. The backing tube 1103 may be metallic with an insulating layer 1105 on top, or the backing tube may be insulating itself, in which case an additional insulating layer 1105 can be omitted. FIG. 11(a) shows a mixed 3D / cross-sectional view, where part of the backing tube and the insulating layer 1105 have been cut half way through, while the electrode(s) 1104 has/have been cut at another location, for illustrative purposes only. FIG. 11(b) shows a top view for illustrating the position of the helical electrode(s).

The one or more helical electrode(s) 1104 can be powered in any manner described above. In particular, the electrode(s) 1104 may be powered via one or more cables (e.g. coax cables or insulated RF conductors, as shown in FIG. 4 or FIG. 5), or conductively via a conductive flange and/or conductive bracket (as shown in FIG. 6 or FIG. 7), or capacitively via an inner tube or magnet bar 1106 and through the cooling liquid (as shown in FIG. 8 or FIG. 9 or FIG. 10).

In an alternative embodiment (not shown), the helical electrode 1104 can comprise several helical electrodes, for example three helical electrodes, or more than three electrodes, each being individually powered via e.g. one or more coax cables or via one or more insulated RF conductors or via one or more conductive bars or rod or strip embedded in the insulation layer 1105. The electrodes may be supplied with the same RF power signal, or with different RF power signals. In order to obtain a more uniform electrical field, the pitch of the helix may be modified so as to compensate at least partly against local maxima or minima which could occur due to standing-wave-effects.

**FIG. 12** shows an example of a cylindrical structure or a rotational target 1200 according to an embodiment of the present invention, wherein a plurality of electrodes 1204 are designed as shaped conductors for acting as antennas, arranged on an insulating layer 1205 outside of a metallic backing tube, or outside of an insulating backing tube. FIG. 12(a) schematically shows the relative position of some of the electrodes on the surface, as seen from a direction perpendicular to the surface. The electrodes 1204 may have any form of known antennas, for example but not limited to monopole antennas, dipole antennas, folded antennas, microstrip-antenna, F-shaped antenna, loop antenna, spiral antenna, helical antenna, or any combination thereof.

It is recognized that the length of these electrodes 1204 may not necessarily be ideal for maximum antenna radiation efficiency when being powered by the envisioned RF frequencies, e.g. 13.56 MHz, but that fact is accepted. In fact, the lengths of the antennas 1204, as well as their positions are preferably chosen so as to obtain a more uniform electrical field. The principle is illustrated in FIG. 12(a), where exemplary waveforms (which may differ from the real waveforms) are shown with a minimum at the feeding point, and a maximum at the ends of the electrode.

The multiple electrodes 1204 are preferably organized such that the minimum of the waveform of one antenna (e.g. point A) is located in the vicinity of the maximum of the waveform emitted by an adjacent antenna (e.g. point B), and vice versa (see e.g. points C and D). This can e.g. be achieved by organizing the electrodes 1204 in parallel, by optionally shifting them, by optionally choosing different lengths and/or size and/or shape and/or by choosing suitable positions of their feeding points.

**FIG. 12(b)** shows a cross sectional view in a plane perpendicular to the longitudinal axis. In the example of FIG. 12(b) electrodes 1204 are located at multiples of 22.5° and their dimensions are exaggerated for illustrative purposes, but this is merely an example, and in practice the electrodes 1204 may be organized at smaller or larger angular distances. Electrical interconnections 1222 (indicated in black) may be arranged therebetween, depending on how the RF power is applied (as described above). The interconnections 1222 are preferably shielded (not shown), and can be used for transporting power from the flange and/or bracket (not shown) to feeding points 1201 of the electrodes. Those electrodes 1204 having a feeding point at the outer ends of the tube, can be directly powered by the flange in a manner similar to the connection shown in FIG. 6. The grounding of the shielding strip may be connected separately if so desired. Alternatively, RF power can be applied to the electrodes via a plurality of-coax cables or insulated RF conductors (as shown in FIG. 5), or conductively (as shown in FIG. 6), or capacitively (as shown in FIG. 7 to FIG. 10) without there being a "physical connector" as feeding point.

It is pointed out that the wavelength of an RF signal of about 13.56 MHz would be about 22.2 m in vacuum. However, considering the presence of a plasma, the actual waves may have a wavelength smaller than 10 m (at f=13.56 MHz), possibly even lower than 3.0 m, due to the impedance of the plasma. In the simulation results of FIG. 3, the wavelength of the standing wave was simulated to be about 2.66 m, but this value is derived from assumptions which may be different in reality, and may vary with temperature, pressure, or other parameters inside a sputter chamber, but, it can be measured. In fact, the skilled person may want to measure the waveforms for a few cylindrical sputter targets having different lengths of interest, in a real sputter chamber. And once these waveforms are known, he can determine the local maxima and minima, and he can derive the actual wavelength, and he can choose a proper length of the electrodes 1204, so that the waveforms would at least partly compensate each other.

**FIG. 13** is a schematic representation of a variant of the embodiment shown in FIG. 11, whereby RF power is applied from only one end of the cylindrical structure (e.g. from a single mounting assembly or a single end-block, similar to the example shown in FIG. 6), by adding additional interconnections 1322 for those electrodes which were powered from the right side of the drawing in FIG. 12. In the embodiments shown in FIG. 12 and FIG. 13, two or three electrodes are organized in line with each other, but the invention is of course not limited to this example, and other configurations with more electrodes in line with each other, or less electrodes in line with each other, may also be used.

**FIG. 14** shows a variant of the embodiment of FIG. 13, where some electrodes 1404a have a first length L1, and other electrodes 1404b have a second length L2 different from the first, whereby the length L1 and L2 are chosen such that minima of the waveforms of the shorter electrodes 1404a substantially coincide with maxima of the longer electrodes 1404b, and vice versa. In the example shown, the short electrode 1404a has a feeding point at the outer end, and the longer electrode 1404b has a feeding point in the middle, but that is not absolutely required, and the feeding points may be located elsewhere on said electrode, for example both in the middle, or both at the outer ends of the cylindrical tube, or both at the inner ends.

Whereas the size and shape of the electrodes shown in FIG. 14 only have one of two possible sizes, that is not absolutely required, and electrodes of (many or gradually) different sizes and shapes may also be used, whereby the size and shape of the electrodes are preferably chosen so as to achieve a more uniform electrical field and/or a more uniform erosion of the target material and/or a more uniform deposition of target material on the substrate.

The interconnection means 1422 (shown in black lines) may be located underneath the electrodes 1404, or may be routed between the electrodes (e.g. in a zig-zag manner), in ways well known in the art, but not shown in the drawing for illustrative purposes. As is also well known, several interconnections can be stacked on top of each other, if required or desired.

**FIG. 15** shows a particularly interesting embodiment, whereby all the electrodes 1504 (only four electrodes are shown) extend over substantially the entire length of the cylindrical structure 1500, and whereby each electrode 1504 is powered at one end, but whereby adjacent electrodes are powered from different sides of the cylindrical structure or sputter target. In this embodiment, all the electrodes can be directly powered by the mounting assembly (e.g. conductive flange and conductive bracket), without the need for interconnections (such as indicated by the thick black lines in FIG. 12 to FIG. 14). By choosing an appropriate length of the parallel electrodes, for example 1.5 times λ, or 2.5 times λ, or 3.5 times λ, assuming that the standing waveform pattern indeed has a sinusoidal pattern as shown in FIG. 3, then indeed the local maxima and local minima of two adjacent electrodes would be located near each other. In the simulation results of FIG. 3 are correct, that would mean that the electrodes 1504 may have a length of about 1.5 x 1.33 m = about 2.0 m. But of course the invention is not limited to this example, and lengths other than 1.5 or 2.5 or 3.5 times λ may also be used.

**FIG. 16** shows a variant of the embodiment of FIG. 15, whereby RF power is applied from only a single side of the cylindrical structure (in the drawing: the left side), by making use of electrical interconnections 1622, as explained above. This has the advantage that only a single end block is needed, or in the case where two end blocks are foreseen anyway, e.g. for mechanical reasons, that only one of the end block needs to provide RF power.

**FIG. 17** shows an optional feature that can be used by any of the electrode(s) shown in the previous embodiments. What is shown is that the shape of the electrode(s) 1704 is not constant, but may vary over the axial length of the cylindrical structure. For example, the height (measured in radial direction) of the electrode(s) 1704 may vary over its length. In the example of FIG. 17, the inner surface of the electrode 1704 is cylindrical, while the outer surface is not. In the example of FIG. 18, the outer surface of the electrode 1704 is cylindrical, while the inner surface is not. It is of course also possible (not shown) that neither of the inner or outer surface are cylindrical. In effect, the thickness of the electrode 1704 is varied in the axial direction. This principle can of course also be applied to non-cylindrical electrodes, such as e.g. to the elongated electrodes of FIG. 12, FIG. 13, FIG. 15, FIG. 16, meaning that the thickness of the electrodes may vary over their length, and can also be applied to the triangular shapes of FIG. 14. In this case, it would even be possible to vary the thickness of the shapes in two dimensions. In general, the thickness of any geometry chosen for the electrodes may be varied in axial direction, in such a way that the resulting electrical field is more uniform.

The effect of the varying shape, e.g. the non-constant thickness is that, during operation, the local distance between the plasma (not shown) outside the cylindrical structure 1700 and the electrode(s) 1704 varies, which has an influence on the capacitance between the electrodes and the plasma, and hence on the electromagnetic waves generated by the electrode(s). This can be used to increase the uniformity of the electronic waves generated by the electrode(s), hence may help to obtain a more uniform erosion of the layer 1708 with sputter material(s) and/or to obtain a more uniform deposited layer. Of course, the shape of the electrode(s) is not limited to the particular shape shown in FIG. 17 or FIG. 18 with a single local minimal thickness substantially in the center of the tube, and other shapes found suitable by the person skilled in the art, are also possible.

Although specific embodiments have been described here above, many variations can be applied by the skilled person. For example, although not all embodiments are shown with magnets (for illustrative purposes), it is contemplated that magnets can be present in all embodiments described above, but that is not absolutely required. The above mentioned inner tube (above also referred to as "magnet bar"), even when having no magnets inside, may be used for conducting cooling liquid and/or conducting RF power. In several embodiments shown above, the magnets extend over only part of the length of the cylindrical target. This is only for illustrative purposes, and should not be interpreted as if the length of the magnets is deliberately shorter than the length of the cylindrical structure. When present, the magnets may be fixedly mounted to the inner tube structure, or may be manually adjustable (outside of the sputter chamber), or may be on-line adjustable (inside the sputter chamber). The option of being able to regulate the position, in particular the distance between the magnets and the outer surface of the inner tube, provides yet another degree of freedom to help achieve a more uniform erosion of the target material. Although this technique is known already per se, it is not known in combination with the cylindrical structures described herein. Although not all embodiments are shown with explicit means for cooling, it is envisioned that all embodiments can be adapted with means for passing a cooling liquid in ways known in the art. Additional insulation or sealing means (e.g. O-rings) for avoiding leakage of the coolant are not shown, but can be applied as required or as desired. In all embodiments shown, the inner tube (e.g. 406) or the magnet bar (e.g. 416) and the magnets are meant to be stationary with respect to the sputter device, whereas the rest of the structure, in particular the backing tube (e.g. 403) and the layers attached thereto, are rotatable, either continuously or in a back and forth manner. In some of the drawings the inner tube extends outside the backing tube, again for illustrative purposes only, to give a visual hint that the inner tube is stationary, while the backing tube etc. is rotatable. Although not explicitly mentioned, the RF power supply may comprise (and typically does comprise) a so called "RF tuner" or "impedance matching circuit", for optimizing the power delivered to the electrode structure and for minimizing reflections. This is well known in the art, and therefore need not be further explained herein. Although not (always) explicitly mentioned, the second end of the backing tube (in case no RF power is applied to that side) can (electrically) be left open or can be terminated by an impedance, e.g. a pure resistive impedance, or a reactive impedance. Although not explicitly mentioned above, for the embodiments where the backing tube is electrically conductive and electrically insulated from the electrode, a DC voltage may also be applied to the backing tube in addition to the RF voltage (superposition) being applied to the electrode(s). Alternatively or in combination therewith, for embodiments where the inner tube is electrically conductive and electrically insulated from the electrode (e.g. in FIG. 4, FIG. 5 and FIG. 6), a DC voltage may be applied to the inner tube in addition to the RF voltage being applied to the electrode(s). It is noted that in all embodiments, except the one shown in FIG. 7, the backing tube may be electrically insulating, which means that the backing tube and the insulating layer may be one and the same layer.

**REFERENCES:**

| | |
|---|---|
| -00: cylindrical structure | -01: feeding point |
| -02: cable, e.g. shielded cable, coax cable, insulated RF conductor | |
| -03: backing tube | -04: electrode |
| -05: insulating layer | -06: inner tube |
| -07: magnet | -08: layer with sputter material |
| 410, 411: curve | -12: opening |
| -16: magnet bar | -17: flange |
| -18: bracket | -20: RF power signal (RF current) |
| -21: isolation layer | -22: interconnection (e.g. bar, rod, strip) |
| -24: inner electrode | -25: dielectric |
| -34: inner electrode | 750: capacitor |

## Claims

1. A cylindrical structure (400) for use in an RF sputter process, **characterized in that** the cylindrical structure (400) comprises:
- a backing tube (403) comprising or consisting of a layer (405) of an electrically insulating material; and
- at least one electrode (404) arranged at least partly within or at least partly on top of said electrically insulating material, said electrode (404) being adapted for receiving RF power from an RF power source,
wherein the at least one electrode (404) has such a shape and size that a substantially uniform electrical field for sputtering is created outside of the cylindrical structure, when used in a sputter system and when being powered, in use, by an RF power source.

2. The cylindrical structure (400) according to claim 1, further comprising an outer layer comprising a sputter material (408) arranged on top of said at least one electrode (404).

3. The cylindrical structure (400) according to claim 2, wherein the sputter material (408) of the outer layer is an electrically insulating material.

4. The cylindrical structure (400) according to any of the previous claims, wherein the backing tube (403) mainly contains an electrically non-conductive material.

5. The cylindrical structure (400) according to any of the claims 1 to 3, wherein the backing tube (403) comprises an electrically conductive material surrounded by an insulating outer layer.

6. The cylindrical structure (700) of claim 5, wherein the insulating layer (705) further comprises a plurality of capacitors (750), the value of which capacitors varies over the length of the cylindrical structure and is specifically adapted for creating a substantially uniform electrical field when being powered at a predefined RF frequency in the presence of a plasma.

7. The cylindrical structure (400) according to any of the previous claims, wherein the at least one electrode (404) comprises at least one feeding point (401).

8. The cylindrical structure (400) according to claim 7, further comprising an inner tube (406) and at least one coax cable (402) or at least one insulated RF conductor extending inside said inner tube (406) over at least part of its length, the coax cable (402) or the insulated RF conductor being connected at one end to said feeding point (401) and being connectable at an opposite end to an RF power source.

9. The cylindrical structure (400) according to claim 7 or 8, wherein the insulating layer (405) further comprises electrical interconnection means (1422) connected at one end to the at least one feeding point (401), and extending towards an extremity of the cylindrical structure (400) for allowing connection to the RF power source.

10. The cylindrical structure (400) according to any of the previous claims, wherein the at least one electrode (404) is a single electrode.

11. The cylindrical structure (400) according to any of the claims 1 to 9, wherein the at least one electrode (404) is a plurality of electrodes.

12. The cylindrical structure (400) according to any of the previous claims, wherein the at least one insulating layer (405) and/or the at least one electrode (404) has a shape and/or size which varies in the axial direction of the cylindrical structure (400) and is specifically adapted for creating the substantially uniform electrical field, when being powered at a predefined RF frequency in the presence of a plasma.

13. A magnetron assembly comprising:
- the cylindrical structure (400) according to any of the previous claims, and
- a first mounting assembly (617) for rotatably mounting said cylindrical structure (400) in a sputtering installation, mounted at one end of said cylindrical structure (400).

14. The magnetron assembly of claim 13, further comprising a second mounting assembly mounted at the opposite end of said cylindrical structure.

15. A sputtering system comprising:
- the magnetron assembly according to claim 13 or 14;
- at least one RF power supply and an RF matching tuner connected to said at least one interconnection means (1422).

## Patentansprüche

1. Zylindrische Struktur (400) zur Verwendung in einem HF-Sputterverfahren, **dadurch gekennzeichnet, dass** die zylindrische Struktur (400) umfasst:
- ein Sicherungsrohr (403), umfassend eine oder bestehend aus einer Schicht (405) eines elektrisch isolierenden Materials; und
- mindestens eine Elektrode (404), die mindestens teilweise innerhalb oder mindestens teilweise oben auf dem elektrisch isolierenden Material angeordnet ist, wobei die Elektrode (404) angepasst ist, um HF-Leistung von einer HF-Leistungsquelle zu empfangen,
wobei die mindestens eine Elektrode (404) eine solche Form und Größe aufweist, dass ein im Wesentlichen gleichmäßiges elektrisches Feld zum Sputtern außerhalb der zylindrischen Struktur erzeugt wird, wenn sie in einem Sputtersystem verwendet und wenn sie, bei Verwendung, von einer HF-Leistungsquelle mit Leistung versorgt wird.

2. Zylindrische Struktur (400) nach Anspruch 1, weiter umfassend eine äußere Schicht, umfassend ein Sputtermaterial (408), das oben auf der mindestens einen Elektrode (404) angeordnet ist.

3. Zylindrische Struktur (400) nach Anspruch 2, wobei das Sputtermaterial (408) der äußeren Schicht ein elektrisch isolierendes Material ist.

4. Zylindrische Struktur (400) nach einem der vorstehenden Ansprüche, wobei das Sicherungsrohr (403) hauptsächlich ein elektrisch nichtleitendes Material enthält.

5. Zylindrische Struktur (400) nach einem der Ansprüche 1 bis 3, wobei das Sicherungsrohr (403) ein elektrisch leitendes Material umfasst, das von einer isolierenden äußeren Schicht umgeben ist.

6. Zylindrische Struktur (700) nach Anspruch 5, wobei die isolierende Schicht (705) weiter eine Vielzahl von Kondensatoren (750) umfasst, wobei der Wert dieser Kondensatoren über die Länge der zylindrischen Struktur variiert und speziell zum Erzeugen eines im Wesentlichen gleichmäßigen elektrischen Felds angepasst ist, wenn sie bei einer vorbestimmten HF-Frequenz in der Anwesenheit eines Plasmas mit Leistung versorgt wird.

7. Zylindrische Struktur (400) nach einem der vorstehenden Ansprüche, wobei die mindestens eine Elektrode (404) mindestens einen Einspeisepunkt (401) umfasst.

8. Zylindrische Struktur (400) nach Anspruch 7, weiter umfassend ein inneres Rohr (406) und mindestens ein Koax-Kabel (402) oder mindestens einen isolierten HF-Leiter, sich innerhalb des inneren Rohrs (406) über mindestens einen Teil seiner Länge erstreckend, wobei das Koax-Kabel (402) oder der isolierte HF-Leiter an einem Ende mit dem Einspeisepunkt (401) verbunden ist und an einem entgegengesetzten Ende mit einer HF-Leistungsquelle verbindbar ist.

9. Zylindrische Struktur (400) nach Anspruch 7 oder 8, wobei die isolierende Schicht (405) weiter elektrische Zwischenverbindungsmittel (1422) umfasst, die an einem Ende mit dem mindestens einen Einspeisepunkt (401) verbunden sind und sich hin zu einer Extremität der zylindrischen Struktur (400) erstrecken, um eine Verbindung mit der HF-Leistungsquelle zu ermöglichen.

10. Zylindrische Struktur (400) nach einem der vorstehenden Ansprüche, wobei die mindestens eine Elektrode (404) eine Einzelelektrode ist.

11. Zylindrische Struktur (400) nach einem der Ansprüche 1 bis 9, wobei die mindestens eine Elektrode (404) eine Vielzahl von Elektroden ist.

12. Zylindrische Struktur (400) nach einem der vorstehenden Ansprüche, wobei die mindestens eine isolierende Schicht (405) und/oder die mindestens eine Elektrode (404) eine Form und/oder Größe aufweist, die in der axialen Richtung der zylindrischen Struktur (400) variiert und speziell zum Erzeugen des im Wesentlichen gleichmäßigen elektrischen Felds angepasst ist, wenn sie bei einer vorbestimmten HF-Frequenz in der Anwesenheit von einem Plasma mit Leistung versorgt wird.

13. Magnetronbaugruppe, umfassend:
- die zylindrische Struktur (400) nach einem der vorstehenden Ansprüche, und
- eine erste Montagebaugruppe (617) zum drehbaren Montieren der zylindrischen Struktur (400) in einer Sputterinstallation, die an einem Ende der zylindrischen Struktur (400) montiert ist.

14. Magnetronbaugruppe nach Anspruch 13, weiter umfassend eine zweite Montagebaugruppe, die am entgegengesetzten Ende der zylindrischen Struktur montiert ist.

15. Sputtersystem, umfassend:
- die Magnetronbaugruppe nach Anspruch 13 oder 14;
- mindestens eine HF-Leistungszuführung und einen HF-Anpasstuner, verbunden mit dem mindestens einen Zwischenverbindungsmittel (1422).

## Revendications

1. Structure cylindrique (400) pour une utilisation dans un processus de pulvérisation cathodique RF, **caractérisée en ce que** la structure cylindrique (400) comprend :
- un tube de support (403) comprenant ou constitué d'une couche (405) d'un matériau électriquement isolant ; et
- au moins une électrode (404) agencée au moins partiellement dans ou au moins partiellement sur ledit matériau électriquement isolant, ladite électrode (404) étant adaptée pour recevoir de l'alimentation RF d'une source d'alimentation RF,
dans laquelle l'au moins une électrode (404) a une telle forme et taille qu'un champ électrique sensiblement uniforme pour pulvériser est créé à l'extérieur de la structure cylindrique, lorsqu'elle est utilisée dans un système de pulvérisation et lorsqu'elle est alimentée, en utilisation, par une source d'alimentation RF.

2. Structure cylindrique (400) selon la revendication 1, comprenant en outre une couche extérieure comprenant un matériau de pulvérisation (408) agencé sur ladite au moins une électrode (404).

3. Structure cylindrique (400) selon la revendication 2, dans laquelle le matériau de pulvérisation (408) de la couche extérieure est un matériau électriquement isolant.

4. Structure cylindrique (400) selon l'une quelconque des revendications précédentes, dans laquelle le tube de support (403) contient principalement un matériau électriquement non conducteur.

5. Structure cylindrique (400) selon l'une quelconque des revendications 1 à 3, dans laquelle le tube de support (403) comprend un matériau électriquement conducteur entouré d'une couche extérieure isolante.

6. Structure cylindrique (700) selon la revendication 5, dans laquelle la couche isolante (705) comprend en outre une pluralité de condensateurs (750), la valeur desquels condensateurs varie selon la longueur de la structure cylindrique et est spécifiquement adaptée pour créer un champ électrique sensiblement uniforme lorsqu'elle est alimentée à une fréquence RF prédéfinie en présence d'un plasma.

7. Structure cylindrique (400) selon l'une quelconque des revendications précédentes, dans laquelle l'au moins une électrode (404) comprend au moins un point d'alimentation (401).

8. Structure cylindrique (400) selon la revendication 7, comprenant en outre un tube intérieur (406) et au moins un câble coaxial (402) ou au moins un conducteur RF isolé s'étendant à l'intérieur dudit tube intérieur (406) sur au moins une partie de sa longueur, le câble coaxial (402) ou le conducteur RF isolé étant raccordé à une extrémité dudit point d'alimentation (401) et pouvant être raccordé à une extrémité opposée à une source d'alimentation RF.

9. Structure cylindrique (400) selon la revendication 7 ou 8, dans laquelle la couche isolante (405) comprend en outre un moyen d'interconnexion électrique (1422) raccordé à une extrémité de l'au moins un point d'alimentation (401), et s'étendant vers une extrémité de la structure cylindrique (400) pour permettre la connexion à la source d'alimentation RF.

10. Structure cylindrique (400) selon l'une quelconque des revendications précédentes, dans laquelle l'au moins une électrode (404) est une électrode unique.

11. Structure cylindrique (400) selon l'une quelconque des revendications 1 à 9, dans laquelle l'au moins une électrode (404) est une pluralité d'électrodes.

12. Structure cylindrique (400) selon l'une quelconque des revendications précédentes, dans laquelle l'au moins une couche isolante (405) et/ou l'au moins une électrode (404) a une forme et/ou taille qui varie dans la direction axiale de la structure cylindrique (400) et est spécifiquement adaptée pour créer le champ électrique sensiblement uniforme, lorsqu'elle est alimentée à une fréquence RF prédéfinie en présence d'un plasma.

13. Ensemble de magnétron, comprenant :
- la structure cylindrique (400) selon l'une quelconque des revendications précédentes, et
- un premier ensemble de montage (617) pour monter de manière rotative ladite structure cylindrique (400) dans une installation de pulvérisation, monté à une extrémité de ladite structure cylindrique (400).

14. Ensemble de magnétron selon la revendication 13, comprenant en outre un second ensemble de montage monté à l'extrémité opposée de ladite structure cylindrique.

15. Système de pulvérisation, comprenant :
- l'ensemble de magnétron selon la revendication 13 ou 14 ;
- au moins une alimentation RF et un syntoniseur à adaptation RF raccordé audit au moins un moyen d'interconnexion (1422).
